(19) Europäisches Patentamt
European Patent Office
Office européen des brevets

(11) **EP 4 756 876 A1**

(12) **EUROPEAN PATENT APPLICATION**

(43) Date of publication:
**10.06.2026 Bulletin 2026/24**

(21) Application number: **24307056.2**

(22) Date of filing: **09.12.2024**

(51) International Patent Classification (IPC):
**H01L 23/64** (2006.01)   **H01L 23/66** (2006.01)

(52) Cooperative Patent Classification (CPC):
**H10W 44/20; H03F 1/0288; H03F 1/565; H03F 3/195; H10W 44/501;** H03F 2200/451

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **NXP USA, Inc.**
**Austin TX 78735 (US)**

(72) Inventors:
• **Lembeye, Olivier**
  **31023 Toulouse (FR)**
• **Lemy, Anthony**
  **31023 Toulouse (FR)**

(74) Representative: **Schwarzweller, Thomas**
**NXP Semiconductors Germany GmbH**
**Intellectual Property Group**
**Beiersdorfstraße 12**
**22529 Hamburg (DE)**

(54) **BROADBAND POWER TRANSISTOR DEVICES AND AMPLIFIERS WITH T-MATCH AND RUGGED BASEBAND TERMINATION CIRCUITS AND METHODS OF MANUFACTURE THEREOF**

(57) An RF amplifier includes a transistor die (840, 841), an impedance matching circuit (110, 150, 810, 811, 850, 851), and a baseband termination circuit (160-1, 160-2, 260, 360, 460, 560, 660, 760-1, 760-2, 760-3, 760-4, 860-1, 860-2, 860-3, 860-4). The impedance matching circuit includes a first inductive element (112, 152, 952) connected between a transistor terminal and a first node (118, 158, 818, 819, 858, 859), a second inductive element (116, 154, 954) connected between the first node and an RF input/output, and a first capacitance (114, 156, 956) connected between the first node and a ground reference node. The baseband termination circuit (160-1, 160-2, 260, 360, 460, 560, 660, 760-1, 760-2, 760-3, 760-4, 860-1, 860-2, 860-3, 860-4) includes a multiple-cell resonator (261, 261', 961) and an envelope capacitor (266, 966) coupled in series between the first node and the ground reference node. The multiple-cell resonator includes at least 4 resonator cells (262, 262', 962). Each resonator cell includes an RF isolation inductor (263, 963) and an RF isolation capacitor (264, 964) coupled in parallel between the first node and the envelope capacitor, which form a parallel resonant circuit in proximity to a center operating frequency of the RF amplifier. The baseband termination circuit also includes one or more envelope resistors (265, 665, 965).

FIG. 9

**Description**

TECHNICAL FIELD

Embodiments of the subject matter described herein relate generally to radio frequency (RF) amplifiers, and more particularly to broadband power transistor devices and amplifiers, and methods of manufacturing such devices and amplifiers.

BACKGROUND

Wireless communication systems employ power amplifiers for increasing the power of radio frequency (RF) signals. In a cellular base station, for example, a Doherty power amplifier may form a portion of the last amplification stage in a transmission chain before provision of the amplified signal to an antenna for radiation over the air interface. High gain, high linearity, stability, and a high level of power-added efficiency are characteristics of a desirable power amplifier in such a wireless communication system.

In the field of power amplifier device design, it is becoming increasingly desirable to achieve concurrent multiple-band, broadband amplification. To successfully design a power amplifier device for wideband operation (e.g., up to 400 megahertz signal bandwidth or higher), it is desirable to enable a good broadband fundamental match with a wide baseband termination. However, achieving these goals for high power amplifiers continues to provide challenges to power amplifier device designers, including challenges associated with amplifier ruggedness.

BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.

FIG. 1 is a schematic circuit diagram of a power amplifier circuit, in accordance with an example embodiment;
FIGs 2, 3, 4, 5, and 6 illustrate various example embodiments of baseband termination circuits;
FIG. 7 is a simplified schematic diagram of a Doherty power amplifier, in accordance with an example embodiment;
FIG. 8 is a top view of a packaged RF power amplifier, in accordance with an example embodiment;
FIG. 9 is a top view of a portion of a packaged RF power amplifier device, including an integrated passive device (IPD) that includes portions of an output impedance matching circuit and a baseband termination circuit, in accordance with an example embodiment;

FIG. 10 is an enlarged view of a portion of the IPD of FIG. 9;
FIG. 11 is a cross-sectional, side view of the portion of the RF power amplifier device and the IPD of FIGs 9 and 10 along line 11-11, in accordance with an example embodiment; and
FIG. 12 is a flowchart of a method for fabricating a packaged RF power amplifier device that includes an embodiment of an output impedance matching circuit and baseband termination circuit, in accordance with an example embodiment.

DETAILED DESCRIPTION

Various power amplifier circuits and devices for wideband operation (e.g., up to 400 megahertz signal bandwidth or higher) are disclosed herein, which enable a good broadband fundamental match with a wide baseband termination. According to one or more embodiments, the power amplifier devices and circuits include impedance matching circuits and baseband termination circuits, and the baseband termination circuits are key linearization enablers. As will be discussed in detail below, the baseband termination circuits have a "rugged" design, which enables the power amplifier devices and circuits to handle high currents associated with high power amplification. The baseband termination circuit embodiments may achieve these goals while maintaining excellent RF and baseband performance.

To overcome challenges in designing broadband power amplifiers, embodiments disclosed herein include impedance matching circuity with a T-match circuit topology and a rugged baseband termination circuit. According to one or more embodiments, a shunt capacitor in the impedance matching circuitry has a high enough capacitance value to provide an acceptable RF low-impedance point (referred to herein as a "quasi-RF cold point), along with one or more baseband termination circuits with good RF isolation that are coupled to the quasi-RF cold point. According to one or more embodiments, a baseband termination circuit includes a multiple-cell resonator that provides good isolation of the RF signal power from more sensitive portions of the baseband termination circuit. The baseband termination circuit embodiments may be characterized as "rugged," because they are better able to handle high voltages that may be present at a quasi-RF cold point than conventional baseband termination circuits. This ruggedness is achieved, at least in part, by the innovative design of the multiple-cell resonator embodiments.

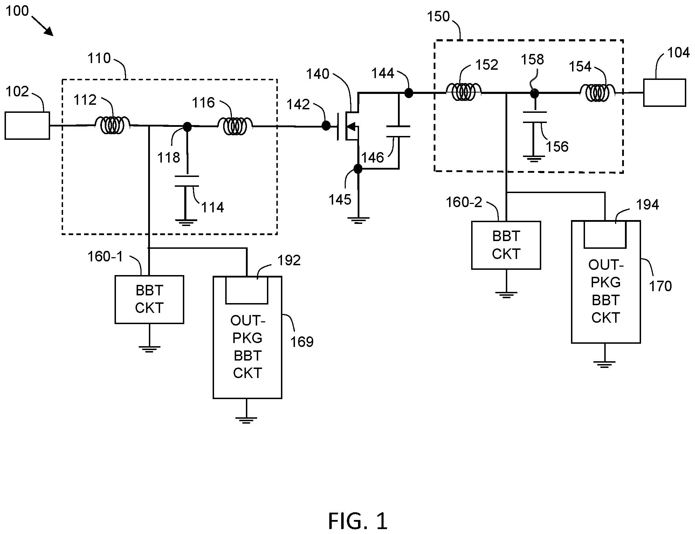

FIG. 1 is a schematic diagram of an RF power amplifier circuit 100. Circuit 100 includes an input 102 (e.g., a first conductive package lead), an input impedance matching circuit 110, a first baseband termination circuit 160-1 (BBT CKT), a transistor 140, an output impedance matching circuit 150, a second baseband termination circuit 160-2, and an output 104 (e.g., a second conductive package lead), according to one or more embodiments. One or more embodiments also may include "out-of-package" (OUT-PKG) baseband termination circuits 169 and/or 170, as well. The input impedance matching circuit 110 and baseband termination circuit 160-1 may be referred to collectively as an "input circuit." The output impedance matching circuit 150 and baseband termination circuit 160-2 may be referred to collectively as an "output circuit." The input 102 and output 104 may be generically referred to as an "RF signal input/output" (I/O).

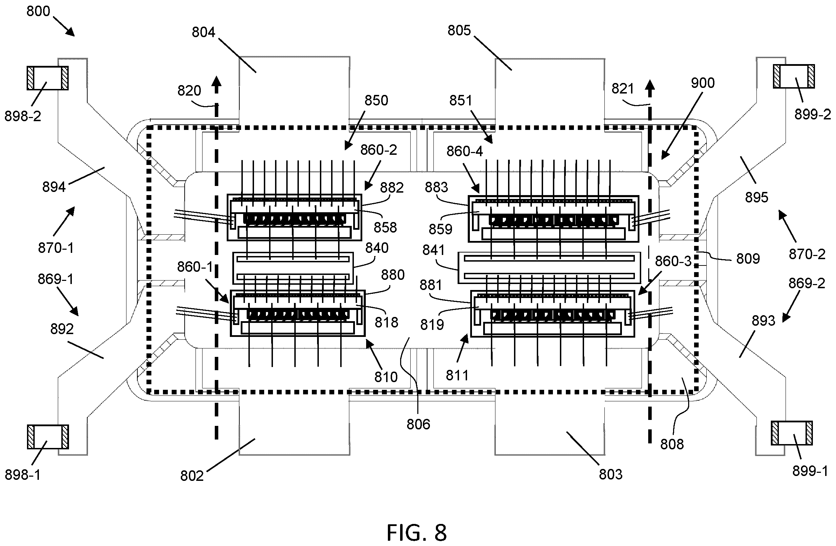

Input 102 and output 104 each may include a conductor, which is configured to enable the circuit 100 to be electrically coupled with external circuitry (not shown). According to one or more embodiments, and as will be discussed in more detail later in conjunction with FIG. 8, each of the input 102 and output 104 may include conductive device leads that are physically positioned to span between the exterior and the interior of a device package.

Input impedance matching circuit 110 and baseband termination circuit 160-1 are electrically coupled between the input 102 and a first terminal 142 of transistor 140 (e.g., the gate terminal of transistor 140). Similarly, output impedance matching circuit 150 and baseband termination circuit 160-2 are electrically coupled between a second terminal 144 of transistor 140 (e.g., the drain terminal of transistor 140) and the output 104.

According to an embodiment, transistor 140 is the primary active component of circuit 100. Transistor 140 includes a control terminal 142 and two current conducting terminals 144, 145, where the current conducting terminals 144, 145 are spatially and electrically separated by a variable-conductivity channel. For example, transistor 140 may be a field effect transistor (FET), which includes a gate terminal (control terminal 142), a drain terminal (a first current conducting terminal 144), and a source terminal (a second current conducting terminal 145). Control terminal 142 may be referred to herein alternatively as gate terminal 142, the first current conducting terminal 144 may be referred to herein alternatively as drain terminal 144, and the second current conducting terminal 145 may be referred to herein alternatively as source terminal 145. Reference to terminals 142, 144, 145 in this manner is not intended to limit the embodiments only to amplifiers that include FETs, but instead is used only for convenience.

According to an embodiment, and using nomenclature typically applied to FETs in a nonlimiting manner, the gate terminal 142 of transistor 140 is coupled to the input 102 through the input impedance matching circuit 110 and the baseband termination circuit 160-1, the drain terminal 144 of transistor 140 is coupled to the output 104 through the output impedance matching circuit 150 and the baseband termination circuit 160-2, and the source terminal 145 of transistor 140 is coupled to a ground reference node (or another voltage reference). Through the variation of control signals provided to the gate of transistor 140, the current between the current conducting terminals 144, 145 of transistor 140 may be modulated.

According to various embodiments, transistor 140 may include a silicon-based FET (e.g., a laterally diffused metal oxide semiconductor (LDMOS) FET), a III-V FET (e.g., a gallium nitride (GaN), gallium arsenide (GaAs), gallium phosphide (GaP), indium phosphide (InP), or indium antimonide (InSb) FET), or another suitable type of FET. The transistor 140 is characterized by a drain-source capacitance, *Cds,* which is represented in FIG. 1 with capacitor 146 between the drain and source terminals 144, 145 of transistor 140. More specifically, capacitor 146 is not a physical component, but instead models the drain-source capacitance of transistor 140. According to some embodiments, transistor 140 may have a relatively low drain-source capacitance (e.g., a drain-source capacitance that is less than about 0.2 pF/W for a silicon-based FET, or a drain-source capacitance that is less than about 0.04 pF/W for a GaN FET), although the drain-source capacitance may be higher, in other embodiments.

Input impedance matching circuit 110 is coupled between the input 102 and the gate terminal 142 of the transistor 140. Input impedance matching circuit 110 is configured to raise the impedance of circuit 100 to a higher (e.g., intermediate or higher) impedance level (e.g., in a range from about 2 to about 10 Ohms or higher). This is advantageous in that it allows the printed circuit board level (PCB-level) matching interface from a driver stage to have an impedance that can be achieved in high-volume manufacturing with minimal loss and variation (e.g., a "user friendly" matching interface).

According to an embodiment, input impedance matching circuit 110 has a T-match configuration, which includes two series-coupled inductive elements 112, 116 and a shunt capacitance 114. A first inductive element 112 (e.g., a first set of wirebonds) is coupled between input 102 and a first intermediate node 118, and a second inductive element 116 (e.g., a second set of wirebonds) is coupled between the intermediate node 118 and the gate terminal 142 of transistor 140. A first terminal of capacitor 114 is coupled to the intermediate node 118, and a second terminal of capacitor 114 is coupled to a ground reference node (or another voltage reference).

The combination of inductive elements 112, 116 and shunt capacitance 114 functions as a low-pass filter. According to an embodiment, the series combination of inductive elements 112, 116 may have an inductance value in a range between about 20 picohenries (pH) to about 3 nanohenries (nH), and shunt capacitance 114 may have a capacitance value in a range between about 5 picofarads (pF) to about 120 pF. According to one or more embodiments, shunt capacitance 114 has a relatively-large capacitance (as indicated above) to provide a relatively low impedance point, at intermediate node 118 and the first terminal of capacitor 114, to signal energy at RF frequencies when compared to the impedances of the baseband termination circuits 160-1, 169 (and a higher impedance than the impedance at the gate terminal 142 of the transistor 140). A point in an RF circuit that is characterized by very low impedance for RF signal energy may be referred to as an "RF cold point." According to one or more embodiments, intermediate node 118 is not a "perfect" RF cold point, in that some voltage at RF frequencies may be present at intermediate node 118 during operation. Accordingly, the intermediate node 118 may be referred to herein as a "quasi-RF cold point."

According to one or more embodiments, a first baseband termination circuit 160-1 is coupled between the intermediate node 118 and the ground reference node (i.e., between the quasi-RF cold point 118 and the ground reference node). The first baseband termination circuit 160-1 may function to improve a low frequency resonance (LFR) of circuit 100 by presenting (at node 118) a low impedance to signal energy at envelope frequencies and a very high impedance to signal energy at RF frequencies. As will be discussed in detail later, embodiments of baseband termination circuit 160-1 include a "multiple-cell resonator" that is configured to isolate the RF signal energy present at intermediate node 118 from the baseband termination portion of the circuit 160-1. Baseband termination circuit 160-1 primarily provides a termination for signal energy at the envelope frequencies, and may be considered to be "invisible" from an RF matching standpoint.

According to one or more embodiments, circuit 100 also may include an additional, input-side, out-of-package baseband termination circuit 169, which also is coupled to the intermediate node 118. As will be discussed in more detail in conjunction with FIG. 8, the out-of-package baseband termination circuit 169 may include a series-coupled inductance and capacitance that is configured to provide a termination for signal energy at very low frequencies (e.g., frequencies below about 100 megahertz (MHz)). A termination of this type should include a relatively large inductance and a relatively large capacitance. For example, the series inductance may have a value in a range between about 1000 pH and about 3000 pH, and the series capacitance may have a value in a range between about 10 nanofarad (nF) and about 20 microfarad ($\mu$F). Because a termination of this type should include relatively large inductance and capacitance, as will be explained in more detail in conjunction with FIG. 8, one or more embodiments of baseband termination circuit 169 implement the inductance using an extra device lead 192 (e.g., lead 892 or 893, FIG. 8) and implement the capacitance using a large capacitor (e.g., capacitor 898-1 or 899-1, FIG. 8) located outside of the device package.

On the output side of the circuit 100, output impedance matching circuit 150 is coupled between the drain terminal 144 of transistor 140 and the output 104. Output impedance matching circuit 150 is configured to match the output impedance of circuit 100 with the input impedance of an external circuit or component (not shown) that may be coupled to output 104.

According to an embodiment, output impedance matching circuit 150 also has a T-match configuration, which includes two series-coupled inductive elements 152, 154 and a shunt capacitance 156. A first inductive element 152 (e.g., a third set of wirebonds) is coupled between drain terminal 144 of transistor 140 and a second intermediate node 158, and a second inductive element 154 (e.g., a fourth set of wirebonds) is coupled between the intermediate node 158 and output 104. A first terminal of capacitor 156 is coupled to the intermediate node 158, and a second terminal of capacitor 156 is coupled to the ground reference node (or another voltage reference).

Again, the combination of inductive elements 152, 154 and shunt capacitance 156 functions as a low-pass filter. According to an embodiment, the series combination of inductive elements 152, 154 may have an inductance value in a range between about 20 pH to about 3 nH, and shunt capacitance 156 may have a capacitance value in a range between about 10 pF to about 140 pF. Again, in some embodiments, shunt capacitance 156 may have a relatively-large capacitance to provide a relatively low-impedance point for RF signal energy at intermediate node 158, when compared to the impedances of the baseband termination circuits 160-2, 170 (e.g., intermediate node 158 corresponds to a second "quasi-RF cold point").

According to one or more embodiments, a second baseband termination circuit 160-2 is coupled between the second intermediate node 158 and the ground reference node (i.e., between the quasi-RF cold point 158 and the ground reference node). Similar to the first baseband termination circuit 160-1, the second baseband termination circuit 160-2 may function to improve the LFR of circuit 100 by presenting (at node 158) a low impedance to signal energy at envelope frequencies and a very high impedance to signal energy at RF frequencies. Again, as will be discussed in detail later, embodiments of baseband termination circuit 160-2 include a "multiple-cell resonator" that is configured to isolate the RF signal energy present at intermediate node 158 from the baseband termination portion of the circuit 160-2. Again, baseband termination circuit 160-2 primarily provides a termination for signal energy at the envelope frequencies, and may be considered to be "invisible" from an RF matching standpoint.

According to one or more embodiments, circuit 100 also may include an additional, output-side, out-of-package baseband termination circuit 170, which also is coupled to the second intermediate node 158. Again, as will be discussed in more detail in conjunction with FIG. 8, the out-of-package baseband termination circuit 170 may include a series-coupled inductance and capacitance that is configured to provide a termination for signal energy at very low frequencies with a relatively large inductance and a relatively large capacitance. For example, the series inductance may have a value in a range between about 1000 pH and about 3000 pH, and the series capacitance may have a value in a range between about 1 µF and about 20 µF. Again, one or more embodiments of baseband termination circuit 170 implement the inductance using an extra device lead 194 (e.g., lead 894 or 895, FIG. 8) and implement the capacitance using a large capacitor (e.g., capacitor 898 or 899, FIG. 8) located outside of the device package.

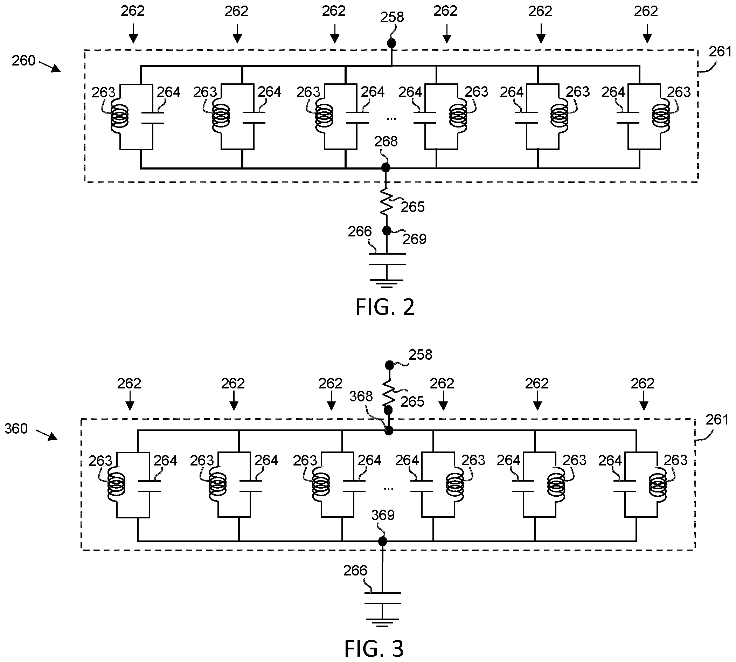

As will now be described in conjunction with FIGs 2-6, baseband termination circuits 160-1 and 160-2 may have any of a number of different circuit configurations, in various embodiments. For example, FIGs 2-6 illustrate five example embodiments of baseband termination circuits 260, 360, 460, 560, 660, each of which may be implemented for baseband termination circuit 160-1 and/or 160-2. It should be understood that baseband termination circuits 160-1 and 160-2 may have a same circuit configuration (e.g., any of circuits 260, 360, 460, 560, 660), or baseband termination circuits 160-1 and 160-2 may use different circuit configurations (e.g., baseband termination circuit 160-1 may utilize circuit 360 while baseband termination circuit 160-2 may utilize circuit 260).

In each of FIGs 2-6, baseband termination circuit 260, 360, 460, 560, 660 is coupled between a connection node 258 (e.g., node 118 or node 158, FIG. 1) and a ground reference node (or another voltage reference). Further, each baseband termination circuit 260, 360, 460, 560, 660 includes a series-coupled circuit with, at least, a multiple-cell resonator 261 (or 661), one or more envelope resistors 265, 665 and an envelope capacitor 266. As will be described below, the arrangement of these components is different for each of the baseband termination circuits 260, 360, 460, 560, 660.

According to one or more embodiments, and as will be described in detail later in conjunction with FIGs 8-11, the components of each baseband termination circuit 260, 360, 460, 560, 660 may be integrally formed as portions of an integrated passive device (IPD), such as IPDs 880-883, FIGs 8-11.

Referring first to FIG. 2, an embodiment of a baseband termination circuit 260 (e.g., either or both of circuits 160-1 or 160-2, FIG. 1) is shown. The baseband termination circuit 260 includes a multiple-cell resonator 261, an envelope resistor 265, and an envelope capacitor 266 coupled in series between an input 258 (e.g., node 118 or 158, FIG. 1) and a ground reference node. Specifically, the multiple-cell resonator 261 is coupled between the input 258 and a first intermediate node 268, the envelope resistor 265 has a first terminal coupled to the first intermediate node 268 and a second terminal coupled to a second intermediate node 269, and the envelope capacitor 266 has a first terminal coupled to the second intermediate node 269 and a second terminal coupled to the ground reference node.

The multiple-cell resonator 261 is configured to isolate RF energy that may be present at input 258 from the envelope capacitor 266. Specifically, the multiple-cell resonator 261 is configured to resonate at or near a center operational frequency of a device or circuit (e.g., amplifier 100, FIG. 1) in which circuit 260 is included, thus providing high impedance at RF frequencies and very low impedance at baseband frequencies (e.g., DC up to about 400 MHz). Said another way, up to an upper boundary of baseband frequencies (e.g., up to about 400 MHz), the multiple-cell resonator 261 can be characterized essentially as an inductance, which is connected between input 258 and intermediate node 268. The capacitance of the multiple-cell resonator 261 is negligible within the baseband frequencies.

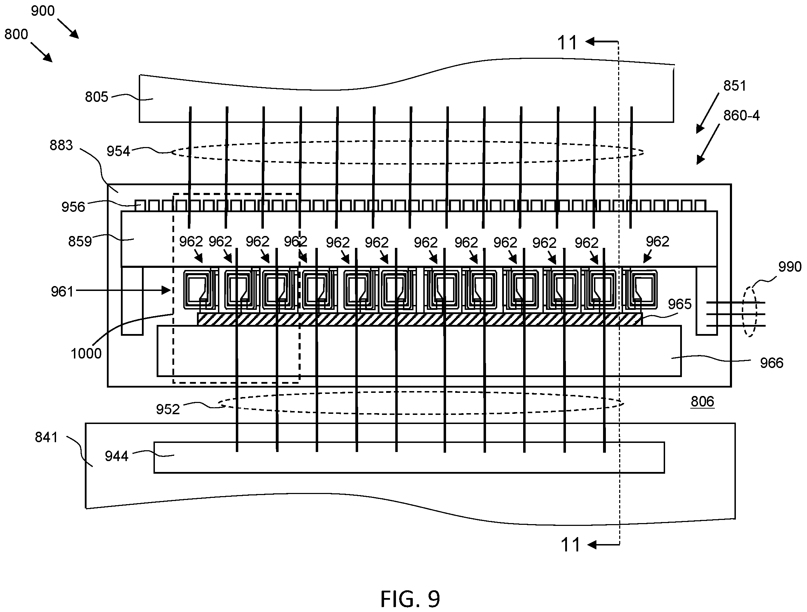

The multiple-cell resonator 261 includes a plurality of resonator "cells" 262 (and a plurality of associated components), where each resonator cell 262 (and the combination of all cells 262) is configured to provide for RF isolation between nodes 258 and 268. According to one or more embodiments, a number, N, of resonator cells 262 included in the multiple-cell resonator 261 is in a range of 4 cells to 20 cells (or more narrowly, a range of 8 to 16 cells), although more cells may be included. According to various embodiments, N is at least 4 (e.g., $4 \leq N < 20$). Although the embodiments illustrated in FIGs 2-6 depict multiple-cell resonators 261 (or 261') with six resonator cells 262 (or 262'), the ellipses between the two center cells indicates that more or fewer cells may be included, in other embodiments. As will be discussed in detail in conjunction with FIGs 9-11, the multiple resonator cells 262 may be arranged side-by-side across the width of a device (e.g., across the width of IPD 883, FIG. 9). According to one or more embodiments, no other circuitry is physically located between adjacent resonator cells 262 of the multiple-cell resonator 261.

Each resonator cell 262 includes an RF isolation inductance 263 and an RF isolation capacitance 264 coupled in parallel. More specifically, first terminals of the RF isolation inductance 263 and the RF isolation capacitance 264 are coupled together (and to input 258), and second terminals of the RF isolation inductance 263 and the RF isolation capacitance 264 are coupled together (and to intermediate node 268). Each parallel-coupled RF isolation inductance 263 and RF isolation capacitance 264 forms a parallel resonant circuit at frequencies in proximity to the center operational frequency of the device or circuit (e.g., circuit 100) within which circuit 260 is incorporated. Because the RF isolation inductance 263 and the RF isolation capacitance 264 form a parallel resonant circuit at frequencies in proximity to the center operational frequency of the device, the multiple-cell resonator 261 (and each of the resonator cells 262) essentially appears as an open circuit to such frequencies. Accordingly, RF energy near the center operational frequency that may be present at the node 258 to which circuit 260 is coupled will be deflected by the parallel resonant circuit formed from the RF isolation inductance 263 and the RF isolation capacitance 264. For this reason, circuit 260 may significantly improve the LFR of a device or circuit (e.g., circuit 100) in which it is incorporated by presenting a low impedance at envelope frequencies and a high impedance at RF frequencies.

As used herein, and according to an embodiment, the term "in proximity to the center operating frequency" means "within 20 percent of the center operating frequency." Accordingly, for example, when a device has a center operating frequency of 2.0 gigahertz (GHz), a frequency that is "in proximity to the center operating frequency" corresponds to a frequency that falls in a range from 1.8 GHz to 2.2 GHz. Although 2.0 GHz is given as an example center operating frequency, a device may have a center operating frequency that is different from 2.0 GHz, as well. In alternate embodiments, the term "in proximity to the center operating frequency" may mean "within 10 percent of the center operating frequency" or "within 5 percent of the center operating frequency."

The NRF isolation inductances 263 in the N resonator cells 262 provide a combined total RF isolation inductance, $L_{TOT}$, between the input 258 and intermediate node 268. Similarly, *the N* RF isolation capacitances 264 in the N resonator cells 262 provide a combined total isolation capacitance, $C_{TOT}$, between the input 258 and intermediate node 268.

As mentioned in conjunction with FIG. 1, each baseband termination circuit 260 (e.g., circuits 160-1, 160-2, FIG. 1) may be coupled to a quasi-RF cold point (e.g., to node 118 or 158, FIG. 1) in an amplifier, where the quasi-RF cold point may experience non-trivial RF voltages during operation of the amplifier. To ensure that the baseband termination circuit 260 is capable of withstanding the current associated with the RF voltages that may be present at the quasi-RF cold point during operation, the baseband termination circuit 260 should be designed with a total RF isolation inductance, $L_{TOT}$, that is capable of handling the anticipated current. A single inductor having a value of $L_{TOT}$ may be physically undesirably large (layout wise) in order to withstand the anticipated current. Accordingly, in one or more embodiments, *A* parallel-coupled inductances alternatively are used to provide the desired total RF isolation inductance, $L_{TOT}$. Using multiple parallel-coupled inductances (i.e., the N inductances 263 in the *N* resonator cells 262) provides the desirable technical effect of increasing the ruggedness of the baseband termination circuit 260 because the total anticipated current is divided between the *N* parallel-coupled resonator cells 262.

Again, the total RF isolation inductance, $L_{TOT}$, of the baseband termination circuit 260 is provided by the *N* RF isolation inductors 263, which are coupled in parallel with each other between input 258 and intermediate node 268. Assuming that the inductance value, $L_{263}$, of each RF isolation inductor 263 is equal, a total RF isolation inductance value, $L_{TOT}$, of the *N,* parallel-coupled RF isolation inductors 263 is given by:

$$L_{TOT} = L_{263} / N .$$

Conversely, the inductance value, $L_{263}$, of each RF isolation inductor 263 is given by:

$$L_{263} = N \times L_{TOT} .$$

According to one or more embodiments, the total RF isolation inductance value, $L_{TOT}$, is in a range between about 5 pH to about 500 pH, and each RF isolation inductance 263 has an inductance value in a range between about $N$ x 5 pH to about N x 500 pH.

Because each of the *N RF* isolation inductors 263 has a relatively high value (e.g., $N$ x $L_{TOT}$), and because it is desirable for the *N* RF isolation inductors 263 to fit in a relatively small area, each RF isolation inductance 263 may be implemented as an integrated spiral inductor (e.g., spiral inductor 963, FIG. 9), in one or more embodiments. As will be explained in more detail later, an integrated spiral inductor may provide a relatively high inductance within a relatively small area because the spiral structure enables a long electrical length to be achieved between relatively closely-spaced terminals. Additionally, the spiral may be designed to have significant mutual inductance, which further increases the inductance value of the spiral inductor.

Again, the envelope resistor 265 is electrically coupled between the first intermediate node 268 and the second intermediate node 269. In various embodiments, the envelope resistor 265 may be implemented as an integrated resistor (e.g., resistor 965, FIG 9) or as a discrete resistor. In one or more embodiments, the envelope resistor 265 may have a resistance value in a range between about 0.1 ohm to about 5.0 ohm, although envelope resistor 265 may have a resistance value outside of this range, as well.

The envelope capacitor 266 is electrically coupled between the second intermediate node 269 and the ground reference node. The envelope capacitor 266 may be implemented as an integrated capacitor (e.g., capacitor 966, FIG. 9), in an embodiment, or as a discrete capacitor, in another embodiment. In one or more embodiments, envelope capacitor 266 may have a capacitance value in a range between about 1 nanofarad (nF) to about 1 microfarad ($\mu$F). In other embodiments, envelope capacitor 266 may have a capacitance value outside of this range.

Referring next to FIG. 3, another embodiment of a baseband termination circuit 360 (e.g., either or both of circuits 160-1 or 160-2, FIG. 1) is shown. The baseband termination circuit 360 includes an envelope resistor 265, a multiple-cell resonator 261, and an envelope capacitor 266 coupled in series between an input 258 (e.g., node 118 or 158, FIG. 1) and a ground reference node. Specifically, the envelope resistor 265 has a first terminal coupled to the input 258 and a second terminal coupled to a first intermediate node 368, the multiple-cell resonator 261 is coupled between the first intermediate node 368 and a second intermediate node 369, and the envelope capacitor 266 has a first terminal coupled to the second intermediate node 369 and a second terminal coupled to the ground reference node.

The envelope resistor 265, multiple-cell resonator 261, and envelope capacitor 266 in the baseband termination circuit 360 may be substantially similar or identical to the envelope resistor 265, multiple-cell resonator 261, and envelope capacitor 266 discussed in conjunction with FIG. 2. For the purpose of brevity, the details and various embodiments of these circuits and components that were discussed above in conjunction with FIG. 2 are not repeated here, but those details and various embodiments apply equally to the envelope resistor 265, multiple-cell resonator 261, and envelope capacitor 266 of baseband termination circuit 360. Accordingly, such details and various embodiments are intended to be incorporated into and apply to description of FIG. 3.

The primary difference between the baseband termination circuits 260, 360 of FIGs 2 and 3 is in the series arrangement of components and circuits between the input 258 and the ground reference node. Specifically, whereas the baseband termination circuit 260 of FIG. 2 has a series arrangement of the multiple-cell resonator 261, the envelope resistor 265, and the envelope capacitor 266 in that order, the baseband termination circuit 360 of FIG. 3 swaps the envelope resistor 265 and the multiple-cell resonator 261 to have a series arrangement of the envelope resistor 265, the multiple-cell resonator 261, and the envelope capacitor 266 in that order. Other than this difference, the baseband termination circuits 260, 360 and their components and circuits function essentially the same.

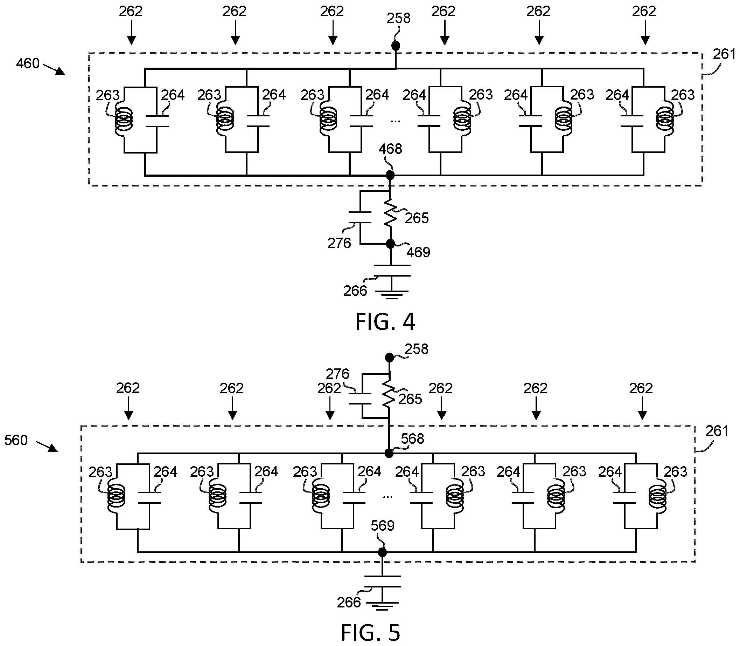

Referring next to FIG. 4, another embodiment of a baseband termination circuit 460 (e.g., either or both of circuits 160-1 or 160-2, FIG. 1) is shown. The baseband termination circuit 460 includes a multiple-cell resonator 261, an envelope resistor 265, a bypass capacitor 276, and an envelope capacitor 266. The multiple-cell resonator 261, envelope resistor 265, and envelope capacitor 266 are coupled in series between an input 258 (e.g., node 118 or 158, FIG. 1) and a ground reference node. Specifically, the multiple-cell resonator 261 is coupled between the input 258 and a first intermediate node 468, the envelope resistor 265 has a first terminal coupled to the first intermediate node 468 and a second terminal coupled to a second intermediate node 469, and the envelope capacitor 266 has a first terminal coupled to the second intermediate node 469 and a second terminal coupled to the ground reference node.

The bypass capacitor 276 is coupled in parallel with the envelope resistor 265. More specifically, first terminals of the bypass capacitor 276 and the envelope resistor 265 are coupled together (and to the first intermediate node 468), and second terminals of the bypass capacitor 276 and the envelope resistor 265 are coupled together (and to the second intermediate node 469).

During operation, the bypass capacitor 276 may function to route RF current around the envelope resistor 265, which may result in a reduction in the RF current dissipated by the envelope resistor 265, and thus a potential increase in efficiency of an amplifier (e.g., amplifier 100, FIG. 1) in which circuit 460 is included. In addition, bypass capacitor 276 may serve to protect the envelope resistor 265 from potential compromise due to excessive current that may otherwise flow through the envelope resistor 265 in the absence of bypass capacitor 276. According to one or more embodiments, bypass capacitor 276 may have a capacitance value in a range between about 3.0 pF to about 1400 pF. In other embodiments, the value of bypass capacitor 276 may be lower or higher than the above-given range.

The multiple-cell resonator 261, envelope resistor 265, and envelope capacitor 266 in the baseband termination circuit 460 may be substantially similar or identical to the multiple-cell resonator 261, envelope resistor 265, and envelope capacitor 266 discussed in conjunction with FIG. 2. For the purpose of brevity, the details and various embodiments of these circuits and components that were discussed above in conjunction with FIG. 2 are not repeated here, but those details and various embodiments apply equally to the multiple-cell resonator 261, envelope resistor 265, and envelope capacitor 266 of baseband termination circuit 460. Accordingly, such details and various embodiments are intended to be incorporated into and apply to description of FIG. 4.

The primary difference between the baseband termination circuits 260, 460 of FIGs 2 and 4 is in the inclusion of the bypass capacitor 276. Other than this difference, the baseband termination circuits 260, 460 and their components and circuits function essentially the same.

Referring next to FIG. 5, another embodiment of a baseband termination circuit 560 (e.g., either or both of circuits 160-1 or 160-2, FIG. 1) is shown. The baseband termination circuit 560 includes an envelope resistor 265, a bypass capacitor 276, a multiple-cell resonator 261, and an envelope capacitor 266. The envelope resistor 265, multiple-cell resonator 261, and envelope capacitor 266 are coupled in series between an input 258 (e.g., node 118 or 158, FIG. 1) and a ground reference node. Specifically, the envelope resistor 265 has a first terminal coupled to the input 258 and a second terminal coupled to a first intermediate node 568, the multiple-cell resonator 261 is coupled between the first intermediate node 568 and a second intermediate node 569, and the envelope capacitor 266 has a first terminal coupled to the second intermediate node 569 and a second terminal coupled to the ground reference node.

Similar to the baseband termination circuit 460 of FIG. 4, in the baseband termination circuit 560 of FIG. 5, the bypass capacitor 276 is coupled in parallel with the envelope resistor 265. More specifically, first terminals of the bypass capacitor 276 and the envelope resistor 265 are coupled together (and to the input 258), and second terminals of the bypass capacitor 276 and the envelope resistor 265 are coupled together (and to the first intermediate node 568).

Again, during operation, the bypass capacitor 276 may function to route RF current around the envelope resistor 265, which may result in a reduction in the RF current dissipated by the envelope resistor 265, and thus a potential increase in efficiency of an amplifier (e.g., amplifier 100, FIG. 1) in which circuit 560 is included. In addition, bypass capacitor 276 may serve to protect the envelope resistor 265 from potential compromise due to excessive current that may otherwise flow through the envelope resistor 265 in the absence of bypass capacitor 276.

The envelope resistor 265, bypass capacitor 276, multiple-cell resonator 261, and envelope capacitor 266 in the baseband termination circuit 560 may be substantially similar or identical to the envelope resistor 265, bypass capacitor 276, multiple-cell resonator 261, and envelope capacitor 266 discussed in conjunction with FIGs 2 and 4. For the purpose of brevity, the details and various embodiments of these circuits and components that were discussed above in conjunction with FIGs 2 and 4 are not repeated here, but those details and various embodiments apply equally to the envelope resistor 265, bypass capacitor 276, multiple-cell resonator 261, and envelope capacitor 266 of baseband termination circuit 560. Accordingly, such details and various embodiments are intended to be incorporated into and apply to description of FIG. 5.

The primary difference between the baseband termination circuits 460, 560 of FIGs 4 and 5 is in the series arrangement of components and circuits between the input 258 and the ground reference node. Specifically, whereas the baseband termination circuit 460 of FIG. 4 has a series arrangement of the multiple-cell resonator 261, the envelope resistor 265/bypass capacitor 276, and the envelope capacitor 266 in that order, the baseband termination circuit 560 of FIG. 5 swaps the envelope resistor 265/bypass capacitor 276 and the multiple-cell resonator 261 to have a series arrangement of the envelope resistor 265/bypass capacitor 276, the multiple-cell resonator 261, and the envelope capacitor 266 in that order. Other than this difference, the baseband termination circuits 460, 560 and their components and circuits function essentially the same.

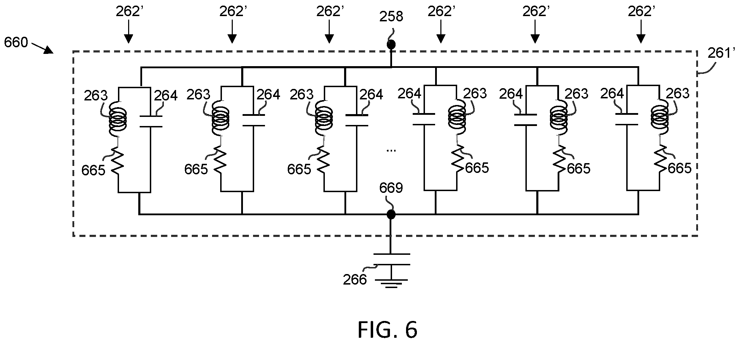

Referring next to FIG. 6, an embodiment of a baseband termination circuit 660 (e.g., either or both of circuits 160-1 or 160-2, FIG. 1) is shown. The baseband termination circuit 660 includes a multiple-cell resonator 261' and an envelope capacitor 266 coupled in series between an input 258 (e.g., node 118 or 158, FIG. 1) and a ground reference node. Specifically, the multiple-cell resonator 261' is coupled between the input 258 and intermediate node 669, and the envelope capacitor 266 has a first terminal coupled to the intermediate node 669 and a second terminal coupled to the ground reference node.

The multiple-cell resonator 261' of FIG. 6 is similar to the multiple-cell resonators 261 of FIGs 2-5, in that the multiple-cell resonator 261' also is configured to isolate RF energy that may be present at input 258 from the envelope capacitor 266. Specifically, the multiple-cell resonator 261' is configured to resonate at or near a center operational frequency of a device or circuit (e.g., amplifier 100, FIG. 1) in which circuit 660 is included, thus providing high impedance at RF frequencies and very low impedance at baseband frequencies (e.g., DC up to about 400 MHz).

Additionally, the multiple-cell resonator 261' also includes a number, N, of resonator cells 262', where each resonator cell 262' (and the combination of all cells 262') is configured to provide for RF isolation between nodes 258 and 669. The number, N, of resonator cells 262 included in the multiple-cell resonator 261' is in a range of 4 cells to 20 cells (or more narrowly, a range of 8 to 16 cells), although more cells may be included.

The resonator cells 262' are similar to the previously-discussed resonator cells 262 (FIGs 2-5), in that each resonator cell 262' includes an RF isolation inductance 263 and an RF isolation capacitance 264 coupled in parallel. However, the resonator cells 262' are different from the previously-discussed resonator cells 262 (FIGs 2-5), in that each resonator cell 262' also includes an envelope resistor 665 coupled in series with the RF isolation inductance 263 between the input 258 and the intermediate node 669. Essentially, the previously-discussed envelope resistors 265 (FIGs 2-5) have been absorbed into (i.e., included within) the resonator cells 262', rather than being coupled outside of the resonator cells 262 (FIGs 2-5).

More specifically, within each resonator cell 262', first terminals of the RF isolation inductance 263 and the RF isolation capacitance 264 are coupled together (and to input 258). The second terminal of the RF isolation inductance 263 is coupled to the first terminal of the envelope resistor 665. Second terminals of the envelope resistor 665 and the RF isolation capacitance 264 are coupled together (and to intermediate node 669).

Other than the above-described difference, the RF isolation inductance 263, RF isolation capacitance 264, and envelope capacitor 266 in the baseband termination circuit 660 may be substantially similar or identical to the RF isolation inductance 263, RF isolation capacitance 264, and envelope capacitor 266 discussed in conjunction with FIG. 2. In contrast with the embodiment of FIG. 2, in baseband termination circuit 660, because the total envelope resistance is distributed across the $N$ *resonator* cells 262', each envelope resistor 665 may have a resistance value of about $N$ x the resistance value of the above-described envelope resistors 265. For the purpose of brevity, the details and various embodiments of these circuits and components that were discussed above in conjunction with FIG. 2 are not repeated here, but those details and various embodiments apply equally to the RF isolation inductance 263, RF isolation capacitance 264, envelope resistor 665, and envelope capacitor 266 of baseband termination circuit 660. Accordingly, such details and various embodiments are intended to be incorporated into and apply to description of FIG. 6.

Referring again to FIG. 1, and as will be described in more detail later in conjunction with FIGs 8-11, various embodiments of RF amplifier devices may include at least one input-side integrated passive device (IPD) assembly (e.g., IPD assemblies 880, 881, FIG. 8), and at least one output-side IPD assembly (e.g., IPD assemblies 882, 883, FIG. 8). The input-side IPD assembly(ies) (e.g., IPD assemblies 880, 881) include portions of the input impedance matching circuit 110 and the baseband termination circuit 160-1. Similarly, the output-side IPD assemblies (e.g., IPD assemblies 882, 883) include portions of the output impedance matching circuit 150 and the baseband termination circuit 160-2. More specifically, each IPD assembly may include a semiconductor substrate with one or more integrated passive components. In one or more embodiments, each input-side IPD assembly may include shunt capacitance 114 and components of baseband termination circuit 160-1 (e.g., components 263, 264, 265, 266, 276, 665, FIGs 2-6). In one or more additional embodiments, each output-side IPD assembly may include shunt capacitance 156 and components of baseband termination circuit 160-2 (e.g., components 263, 264, 265, 266, 276, 665, FIGs 2-6).

In other embodiments, some portions of the input and output impedance matching circuits 110, 150 and baseband termination circuits 160-1, 160-2 may be implemented as distinct/discrete components or as portions of other types of assemblies (e.g., a low-temperature co-fired ceramic (LTCC) device, a small PCB assembly, and so on). In still other embodiments, some portions of the input and/or output impedance matching circuits 110, 150 may be coupled to and/or integrated within the semiconductor die that includes transistor 140. The below, detailed description of embodiments that include IPD assemblies should not be taken to limit the inventive subject matter, and the term "passive device substrate" or "IPD substrate" means any type of structure that includes a passive device, including an IPD, a LTCC device, a transistor die, a PCB assembly, and so on.

In various embodiments, amplifier circuit 100 also may include bias circuitry (not shown in FIG. 1). To provide a bias voltage to the gate terminal 142 and/or to the drain terminal 144 of the transistor 140, an external bias circuit (not shown) may be connected through the input 102, the output 104, and/or through additional package leads to the gate terminal 142 and/or to the drain terminal 144 of the transistor 140, and the bias voltage(s) may be provided through the input 102, output 104, and/or additional leads.

The RF amplifier circuit 100 of FIG. 1 may be utilized as a single-path amplifier, which receives an RF signal at input 102, amplifies the signal through transistor 140, and produces an amplified RF signal at output 104. Alternatively, multiple instances of the RF amplifier circuit 100 may be utilized to provide a multiple-path amplifier, such as a Doherty power amplifier or another type of multiple-path amplifier circuit.

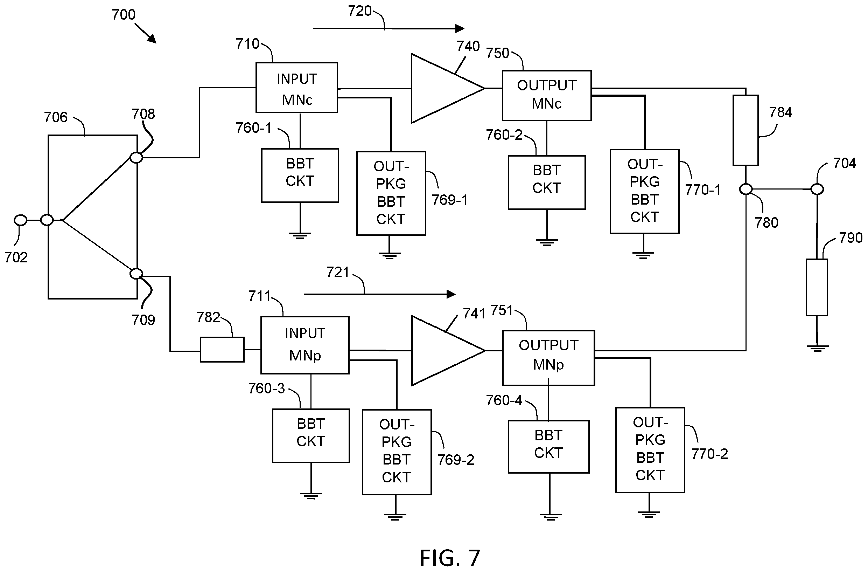

For example, FIG. 7 is a simplified schematic diagram of a Doherty power amplifier 700 in which embodiments of RF power amplifier circuit 100 may be implemented. Amplifier 700 includes an input node 702, an output node 704, a power divider 706 (or splitter), a carrier amplifier path 720, a peaking amplifier path 721, and a combining node 780. A load 790 may be coupled to the combining node 780 (e.g., through an impedance transformer, not shown) to receive an amplified RF signal from amplifier 700.

Power divider 706 is configured to divide the power of an input RF signal received at input node 702 into carrier and peaking portions of the input signal. The carrier input signal is provided to the carrier amplifier path 720 at power divider output 708, and the peaking input signal is provided to the peaking amplifier path 721 at power divider output 709. During operation in a full-power mode when both the carrier and peaking amplifiers 740, 741 are supplying current to the load 790, the power divider 706 divides the input signal power between the amplifier paths 720, 721. For example, the power divider 706 may divide the power equally, such that roughly one half of the input signal power is provided to each path 720, 721 (e.g., for a symmetric Doherty amplifier configuration). Alternatively, the power divider 706 may divide the power unequally (e.g., for an asymmetric Doherty amplifier configuration).

Essentially, the power divider 706 divides an input RF signal supplied at the input node 702, and the divided signals are separately amplified along the carrier and peaking amplifier paths 720, 721. The amplified signals are then combined in phase at the combining node 780. It is important that phase coherency between the carrier and peaking amplifier paths 720, 721 is maintained across a frequency band of interest to ensure that the amplified carrier and peaking signals arrive in phase at the combining node 780, and thus to ensure proper Doherty amplifier operation.

Each of the carrier amplifier 740 and the peaking amplifier 741 includes one or more single-stage or multiple-stage power transistor integrated circuits (ICs) (or power transistor die) for amplifying an RF signal conducted through the amplifier 740, 741. According to various embodiments, all amplifier stages or a final amplifier stage of either or both the carrier amplifier 740 and/or the peaking amplifier 741 may be implemented, for example, using a III-V field effect transistor (e.g., a HEMT), such as a GaN FET (or another type of III-V transistor, including a GaAs FET, a GaP FET, an InP FET, or an InSb FET). Where only one of the carrier amplifier 740 or the peaking amplifier 741 is implemented as a III-V FET, the other amplifier may be implemented as a silicon-based FET (e.g., an LDMOS FET), in some embodiments. In still other embodiments, both the carrier amplifier 740, and/or the peaking amplifier 741 may be implemented as a silicon-based FET.

Although the carrier and peaking power transistor ICs may be of equal size (e.g., in a symmetric Doherty configuration), the carrier and peaking power transistor ICs may have unequal sizes, as well (e.g., in various asymmetric Doherty configurations). In an asymmetric Doherty configuration, the peaking power transistor IC(s) typically are larger than the carrier power transistor IC(s) by some multiplier. For example, the peaking power transistor IC(s) may be twice the size of the carrier power transistor IC(s) so that the peaking power transistor IC(s) have twice the current carrying capability of the carrier power transistor IC(s). Peaking-to-main amplifier IC size ratios other than a 2:1 ratio may be implemented, as well.

During operation of Doherty amplifier 700, the carrier amplifier 740 is biased to operate in class AB mode, and the peaking amplifier 741 is biased to operate in class C mode. At low power levels, where the power of the input signal at node 702 is lower than the turn-on threshold level of peaking amplifier 741, the amplifier 700 operates in a low-power (or back-off) mode in which the carrier amplifier 740 is the only amplifier supplying current to the load 790. When the power of the input signal exceeds a threshold level of the peaking amplifier 741, the amplifier 700 operates in a high-power mode in which the carrier amplifier 740 and the peaking amplifier 741 both supply current to the load 790. At this point, the peaking amplifier 741 provides active load modulation at combining node 780, allowing the current of the carrier amplifier 740 to continue to increase linearly.

Input and output impedance matching networks 710, 750 (input MNc, output MNc) may be implemented at the input and/or output of the carrier amplifier 740. Similarly, input and output impedance matching networks 711, 751 (input MNp, output MNp) may be implemented at the input and/or output of the peaking amplifier 741. In each case, the matching networks 710, 711, 750, 751 may be used to incrementally increase the circuit impedance toward the load impedance and source impedance. As discussed previously, in a particular embodiment, the input and output impedance matching networks 710, 711, 750, 751 each may have a T-match circuit topology that includes a quasi-RF cold point node (e.g., node 118, 158, FIG. 1). Baseband termination circuits 760-1, 760-2, 760-3, 760-4 (e.g., BBT circuits 160-1, 160-2, 260, 360, 460, 560, 660, FIGs 1-6) may be coupled between these quasi-RF cold point nodes and the ground reference. All or portions of the input and output impedance matching networks 710, 711, 750, 751 and the baseband termination circuits 760-1 through 760-4 may be implemented inside a power transistor package that includes the carrier and/or peaking amplifiers 740, 741. Additional out-of-package baseband termination circuits 769-1, 769-2, 770-1, 770-2 (e.g., BBT circuits 169, 170, FIG. 1) also may be coupled between the quasi-RF cold point nodes and the ground reference.

Doherty amplifier 700 has an "inverted" load network configuration. In the inverted configuration, the input circuit is configured so that an input signal supplied to the peaking amplifier 741 is delayed by 90 degrees with respect to the input signal supplied to the carrier amplifier 740 at the center frequency of operation of the amplifier 700. To ensure that the carrier and peaking input RF signals arrive at the carrier and peaking amplifiers 740, 741 with about 90 degrees of phase difference, as is fundamental to proper Doherty amplifier operation, phase delay element 782 applies about 90 degrees of phase delay to the peaking input signal. For example, phase delay element 782 may include a quarter wave transmission line, or another suitable type of delay element with an electrical length of about 90 degrees.

The output circuit also is configured to apply about a 90 degree phase delay to the signal between the output of carrier amplifier 740 and the combining node 780. This is achieved through an additional delay element 784, which also provides an impedance inversion to the amplified carrier signal. Alternate embodiments of Doherty amplifiers may have a "noninverted" load network configuration. In such a configuration, the input circuit is configured so that an input signal supplied to the peaking amplifier 741 is delayed by about 90 degrees or about 270 degrees with respect to the input signal supplied to the carrier amplifier 740 at the center frequency of operation of the amplifier 700, and the output circuit is configured to apply about a 270 degree (or more) phase delay (and impedance inversion) to the signal between the output of the carrier amplifier 740 and the combining node 780.

Amplifiers 740 and 741, along with all or portions of matching networks 710, 711, 750, 751 and baseband termination circuits 760-1 through 760-4 may be implemented in discrete, packaged power amplifier devices. In such devices, input and output leads are coupled to a substrate, and each amplifier 740, 741 may include a single-stage or multiple-stage power transistor also coupled to the substrate. Portions of the input and output matching networks 710, 711, 750, 751 may be implemented as additional components within the packaged device. Further, as is described in detail below, portions of the baseband termination circuits 760-1 through 760-4 (e.g., embodiments of baseband termination circuits 160-1, 160-2, 260, 360, 460, 560, 660, FIGs 1-6) also may be implemented as additional components within the packaged device.

For example, FIG. 8 is a top view of an embodiment of a packaged RF amplifier device 800 that embodies two parallel instances of the circuit 100 of FIG. 1, and which may be utilized to provide amplifiers (e.g., amplifiers 740, 741, FIG. 7), and portions of matching networks (e.g., portions of matching networks 710, 711, 750, 751, FIG. 7) in a Doherty amplifier (e.g., Doherty amplifier 700, FIG. 7). In addition, as will be described in more detail below, device 800 includes two input-side IPD assemblies 880, 881, each of which includes portions of an input impedance matching circuit 810, 811 (e.g., circuit 110, 710, 711 FIGs 1, 7) and a baseband termination circuit 860-1, 860-3 (e.g., circuit 160-1, 260, 360, 460, 560, 660, 760-1, 760-3, FIGs 1-7). Further, device 800 includes two output-side IPD assemblies 882, 883, each of which includes portions of an output impedance matching circuit 850, 851 (e.g., circuit 150, 750, 751 FIGs 1, 7) and an in-package baseband termination circuit 860-2, 860-4 (e.g., circuit 160-2, 260, 360, 460, 560, 660, 760-2, 760-4, FIGs 1-7). For each amplification path 820, 821, an out-of-package baseband termination circuit 869-1, 869-2 (e.g., circuit 169, 769-1, 769-2, FIGs 1, 7) also may be provided at the input side of the device 800, and/or an out-of-package baseband termination circuit 870-1, 870-2 (e.g., circuit 170, 770-1, 770-2, FIGs 1, 7) also may be provided at the output side of the device 800.

Device 800 includes a flange 806 (or "device substrate"), in an embodiment, which includes a rigid electrically-conductive substrate with a thickness that is sufficient to provide structural support for various electrical components and elements of device 800. In addition, flange 806 may function as a heat sink for transistor dies 840, 841 and other devices mounted on flange 806. Flange 806 has top and bottom surfaces (only a central portion of the top surface is visible in FIG. 8), and a substantially-rectangular perimeter that corresponds to the perimeter of the device 800.

Flange 806 is formed from an electrically conductive material, and may be used to provide a ground reference node for the device 800. For example, various components and elements may have terminals that are electrically coupled to flange 806, and flange 806 may be electrically coupled to a system ground when the device 800 is incorporated into a larger electrical system. At least the top surface of flange 806 is formed from a layer of conductive material, and possibly all of flange 806 is formed from bulk conductive material.

An isolation structure 808 is attached to the top surface of flange 806, in an embodiment. Isolation structure 808, which is formed from a rigid, electrically insulating material, provides electrical isolation between conductive features of the device (e.g., between leads 802-805 and flange 806). Isolation structure 808 has a frame shape, in an embodiment, which includes a substantially enclosed, four-sided structure with a central opening. Isolation structure 808 may have a substantially or generally rectangular shape, as shown in FIG. 8, or isolation structure 808 may have another shape (e.g., annular ring, oval, and so on).

A portion of the top surface of flange 806 that is exposed through the opening in isolation structure 808 is referred to herein as the "active area" of device 800. Transistor dies 840, 841 are positioned within the active device area of device 800, along with IPD assemblies 880, 881, 882, 883, which will be described in more detail later. For example, the transistor dies 840, 841 and IPD assemblies 880-883 may be coupled to the top surface of flange 806 using conductive epoxy, solder, solder bumps, sintering, and/or eutectic bonds.

Device 800 houses two amplification paths (indicated with arrows 820, 821), where each amplification path 820, 821 represents a physical implementation of circuit 100 (FIG. 1). When incorporated into a Doherty amplifier (e.g., Doherty amplifier 700, FIG. 7), amplification path 820 may correspond to a carrier amplifier path (e.g., carrier amplifier path 720, FIG. 7), and amplification path 821 may correspond to a peaking amplifier path (e.g., peaking amplifier path 721, FIG. 7).

Each path 820, 821 includes an input lead 802, 803 (e.g., input 102, FIG. 1), an output lead 804, 805 (e.g., output 104, FIG. 1), one or more transistor dies 840, 841 (e.g., transistor 140, FIG. 1 or amplifiers 740, 741, FIG. 7), an input impedance matching circuit 810, 811 (e.g., input impedance matching circuit 110, FIG. 1 or portions of input matching networks 710, 711, FIG. 7), an output impedance matching circuit 850, 851 (e.g., output impedance matching circuit 150, FIG. 1 or portions of output matching networks 750, 751, FIG. 7), input-side baseband termination circuits 860-1, 860-3, 869-1, 869-2 (e.g., baseband termination circuit 160-1, 169, 260, 360, 460, 560, 660, 760-1, 760-3, 769-1, 769-2, FIGs 1,-7), and output-side baseband termination circuits 860-2, 860-4, 870-1, 870-2 (e.g., baseband termination circuits 160-2, 170, 260, 360, 460, 560, 660, 760-2, 760-4, 770-1, 770-2, FIGs 1-7).

The input and output leads 802-805 are mounted on a top surface of the isolation structure 808 on opposed sides of the central opening, and thus the input and output leads 802-805 are elevated above the top surface of the flange 806, and are electrically isolated from the flange 806. Generally, the input and output leads 802-805 are oriented to allow for attachment of wirebonds between the input and output leads 802-805 and components and elements within the central opening of isolation structure 808.

Each transistor die 840, 841 includes an integrated power FET, where each FET has a control terminal (e.g., a gate) and two current conducting terminals (e.g., a drain and a source). A control terminal of a FET within each transistor die 840, 841 is coupled through an input impedance matching circuit 810, 811 to an input lead 802, 803. In addition, one current conducting terminal (e.g., the drain) of a FET within each transistor die 840, 841 is coupled through an output impedance matching circuit 850, 851 to an output lead 804, 805. The other current conducting terminal (e.g., the source) of a FET within each transistor die 840, 841 is electrically coupled through the die 840, 841 to the flange 806 (e.g., to ground), in an embodiment.

Embodiments of the input impedance matching circuits 810, 811 and baseband termination circuits 860-1, 860-3 are not discussed in detail herein. Suffice it to be said that some of the components of these circuits may be implemented within IPD assemblies 880, 881.

Briefly, each input impedance matching circuit 810, 811 is coupled between an input lead 802, 803 and the control terminal of a FET within a transistor die 840, 841. Each input-side, in-package baseband termination circuit 860-1, 860-3 is coupled between a node 818, 819 (e.g., a conductive bond pad corresponding to node 118, FIG. 1) within IPD assembly 880, 881 and a ground reference (e.g., flange 806).

Each input-side, out-of-package baseband termination circuit 869-1, 869-2 includes a combination of an envelope inductance and an envelope capacitance coupled in series between a conductive bond pad 818, 819 (e.g., a quasi-RF cold point node) and ground. The envelope inductance is provided by the series combination of wirebonds (not numbered) and additional lead 892, 893, and the envelope capacitance is provided by a discrete capacitor 898-1, 899-1. More specifically, the first ends of the wirebonds may be connected to the conductive bond pad 818, 819 of an IPD assembly 880, 881, and the second ends of the wirebonds may be connected to a proximal end of the additional lead 892, 893. A first terminal of each envelope capacitor 898-1, 899-1 is coupled to a distal end of an additional lead 892, 893, and a second terminal of each capacitor 898-1, 899-1 is coupled to a ground reference node of a PCB (or other substrate) to which the amplifier device 800 is coupled.

Embodiments of the output impedance matching circuits 850, 851 and in-package baseband termination circuits 860-2, 860-4 will be described in more detail in conjunction with FIGs 9-11, which illustrate the components of these circuits 850, 851, 860-2, 860-4 in greater detail. As will be explained in conjunction with FIGs 9-11, some of the components of these circuits may be implemented within IPD assemblies 882, 883. Briefly, each output impedance matching circuit 850, 851 is coupled between a current conducting terminal (e.g., the drain) of a FET within a transistor die 840, 841 and an output lead 804, 805. Each output-side, in-package baseband termination circuit 860-2, 860-4 is coupled between a node 858, 859 (e.g., an RF low-impedance point (or a quasi-RF cold point node) in the form of a conductive bond pad corresponding to node 158, FIG. 1) within IPD assembly 882, 883 and a ground reference (e.g., flange 806).

In the example of FIG. 8, device 800 includes two transistor dies 840, 841 that essentially function in parallel, although another semiconductor device may include a single transistor die or more than two transistor dies, as well. In addition, device 800 includes two input-side IPD assemblies 880, 881 and two output-side IPD assemblies 882, 883, which also essentially function in parallel. It is to be understood that more or fewer of IPD assemblies 880-883 may be implemented, as well.

According to an embodiment, device 800 is incorporated in an air cavity package, in which transistor dies 840, 841, the IPD assemblies 880-883, and various other components are located within an enclosed air cavity. Basically, the air cavity is bounded by flange 806, isolation structure 808, and a cap (not shown) overlying and in contact with the isolation structure 808 and leads 802-805. In FIG. 8, an example perimeter of the cap is indicated by dashed box 809. In other embodiments, the components of device 800 may be incorporated into an overmolded package (i.e., a package in which the electrical components within the active device area are encapsulated with a non-conductive molding compound, and in which portions of the leads 802-805 also may be encompassed by the molding compound). In an overmolded package, isolation structure 808 may be excluded.

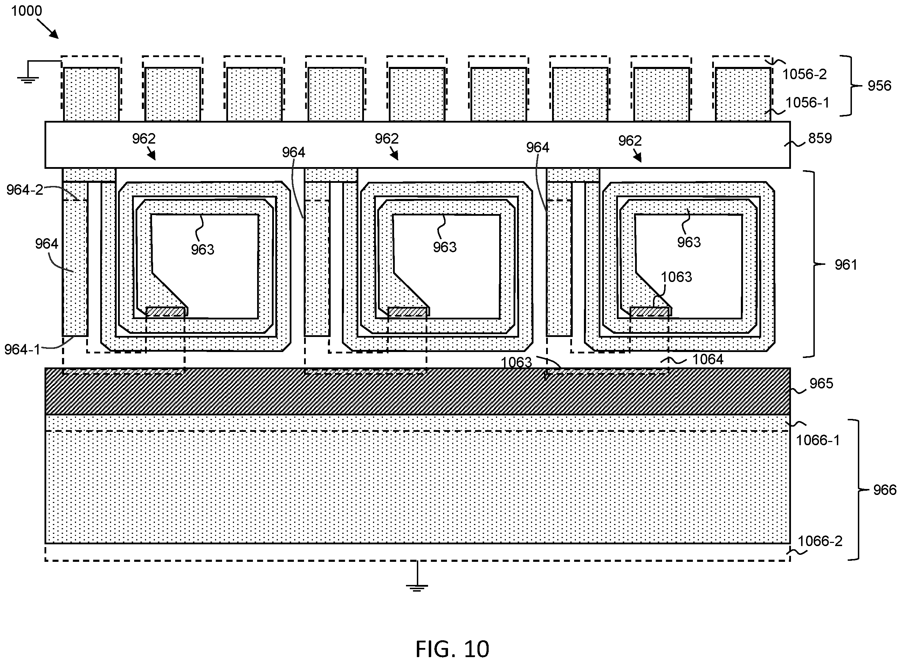

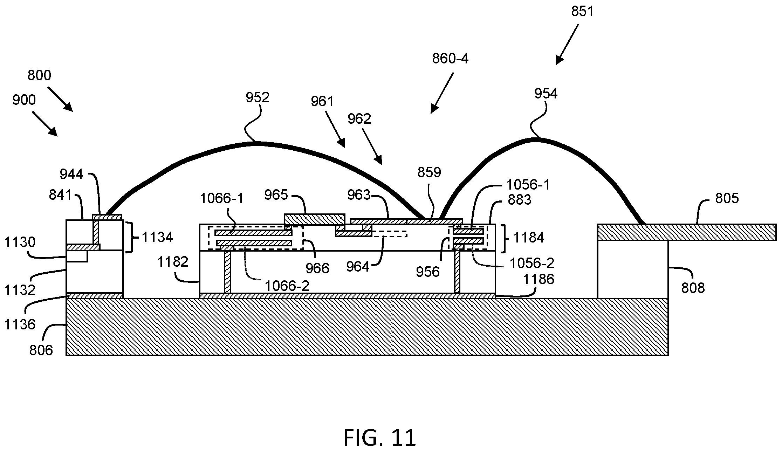

Reference is now made to FIGs 9-11, which include enlarged views of a portion 900 of device 800 that includes embodiments of an output T-match impedance matching circuit 851 (e.g., circuit 150, FIG. 1) and baseband termination circuit 860-4 (e.g., baseband termination circuit 160-2, 260, 360, 460, 560, 660, 760-4, FIGs 1-7). More specifically, FIG. 9 is a top view of the upper-right, output-side portion 900 of the packaged RF power amplifier device 800 of FIG. 8 along amplifier path 821. As shown most clearly in FIG. 9, portion 900 includes a portion of power transistor die 841, a portion of output lead 805, and output-side IPD assembly 883. For enhanced understanding, FIG. 10 includes an enlarged view of portion 1000 of FIG. 9, and FIG. 11 includes a cross-sectional, side view of the portion 900 of the RF power amplifier device of FIG. 9 along line 11-11, in accordance with one or more example embodiments. It should be understood that, although portions 900, 1000 of device 800 shown in FIGs 9-11 depict details of the output circuitry of amplifier path 821, the output circuitry of amplifier path 820 may be substantially the same as the output circuitry along amplifier path 821. More specifically, the output circuitry for both the carrier and peaking amplifier paths may be implemented as shown in FIGs 9-11, and as described in detail below.

As is most clearly illustrated in FIG. 11, the power transistor die 841 and the IPD assembly 883 are coupled to the top surface of the conductive flange 806, and the output lead 805 is electrically isolated from the conductive flange 806 (e.g., using isolation structure 808). Power transistor die 841 includes a transistor output terminal 944 (e.g., a conductive bond pad), which is electrically connected within power transistor die 841 to a first current-conducting terminal (e.g., a drain terminal) of a single-stage or final-stage FET 1130 integrated within the die 841. As discussed previously, each FET 1130 may include a III-V field effect transistor (e.g., a HEMT), such as a GaN FET (or another type of III-V transistor, including a GaAs FET, a GaP FET, an InP FET, or an InSb FET). More specifically, each FET 1130 may be integrally formed in and on a base semiconductor substrate 1132 (e.g., a GaN substrate, a GaN-on-silicon substrate, a GaN-on-silicon carbide substrate, and so on). Conductive connections between the first current-conducting terminal of the FET 1130 (e.g., the drain terminal) and the output terminal 944 of the die 841 may be made through a build-up structure 1134. A conductive layer 1136 on a bottom surface of the die 841 may provide a ground node (e.g., for the source terminal, which may be connected to the conductive layer 1136 (and thus to the conductive flange 806) using through substrate vias or doped sinker regions (not shown).

The IPD assembly 883 also may include a base semiconductor substrate 1182 (e.g., a silicon substrate, a silicon carbide substrate, a GaN substrate, or another type of semiconductor substrate, which may be referred to as an "IPD substrate" herein) and a build-up structure 1184 of alternating dielectric and patterned conductive layers, where portions of the patterned conductive layers are electrically connected using conductive vias. As will be discussed in more detail below, various electrical components of the output impedance matching circuit 851 and the in-package baseband termination circuit 860-4 are integrally formed within and/or connected to the IPD assembly 883. These electrical components may be electrically connected to a conductive bond pad (e.g., bond pad 859) at the top surface of the IPD assembly 883, and also may be electrically connected to the conductive flange 806 (e.g., to ground) using through substrate vias to a conductive layer 1186 on a bottom surface of the IPD assembly 883.

In some embodiments, the output-side IPD assembly 883 more specifically includes a first shunt capacitor 956 (e.g., shunt capacitance 156, FIG. 1) of an output impedance matching circuit (e.g., circuit 150, FIG. 1, 750, 751, FIG. 7, or 850, 851, FIG. 8) and components of an in-package baseband termination circuit (e.g., circuit 160-2, FIG. 1, one of circuits 260, 360, 460, 560, 660, FIGs 2-6, circuit 760-2, 760-4, FIG. 7, or 860-2, 860-4, FIG. 8). In the embodiments of FIGs 9-11, the components of the baseband termination circuit included in IPD assembly 883 more specifically include components of a multiple-cell resonator 961 (e.g., resonator 261 or 261', FIGs 2-6), one or more envelope resistors 965 (e.g., envelope resistor 265 or 665, FIGs 2-6), and an envelope capacitor 966 (e.g., envelope capacitor 266, FIGs 2-6). According to one or more embodiments, and as best seen in FIG. 10, the multiple-cell resonator 961 includes multiple resonator cells 962 (e.g., resonator cells 262, FIGs 2-6), each cell 962 including an RF isolation inductor 963 (e.g., inductance 263, FIGs 2-6) and an RF isolation capacitor 964 (e.g., capacitance 264, FIGs 2-6). Each of these components will be discussed in more detail later.

First, connections between the transistor die 841 and the output lead 805 through the output impedance matching circuit 851 will be described in more detail. More specifically, through the output terminal 944, the first current conducting terminal (e.g., the drain) of a FET 1130 within transistor die 841 is electrically coupled to output lead 805 through an instance of an output impedance matching circuit 851. For example, in an embodiment, output impedance matching circuit 851 has a T-match configuration, which includes two inductive elements 952, 954 (e.g., inductive elements 152, 154, FIG. 1) coupled in series, and a shunt capacitor 956 (e.g., shunt capacitance 156, FIG. 1). A first inductive element 952 (e.g., inductive element 152, FIG. 1) may be implemented as a first set of wirebonds that is coupled between the output terminal 944 of die 841 and a conductive bond pad 859 (e.g., node 158, 258, FIGs 1-6) on a top surface of the IPD assembly 883. A second inductive element 954 (e.g., inductive element 154, FIG. 1) may be implemented as a second set of wirebonds that is coupled between the conductive bond pad 859 and output lead 805.

According to an embodiment, the shunt capacitor 956 of output impedance matching circuit 851 may be implemented as a capacitor (or a set of parallel-coupled capacitors, as best seen in FIGs 9 and 10) that is integrally formed with the IPD assembly 883. For example, shunt capacitor 956 may be implemented as one or more integrated MIM capacitors, which include first and second conductive electrodes (e.g., electrodes 1056-1, 1056-2, FIGs 10, 11), and which may be formed from patterned portions of the conductive layers of build-up structure 1184. The electrodes 1056-1, 1056-2 are aligned with each other and are electrically separated by dielectric material of the build-up structure 1184. A first electrode 1056-1 of each shunt capacitor 956 is electrically coupled to the conductive bond pad 859 (and thus to wirebonds 952 and 954), and a second electrode 1056-2 of each shunt capacitor 956 is electrically coupled to the conductive flange (e.g., using conductive through substrate vias that extend through the semiconductor substrate 1182), in an embodiment. In an alternate embodiment, the shunt capacitor 956 may be implemented using a discrete capacitor coupled to conductive pads at a top surface of the IPD assembly 883, or another type of capacitor may be used.

As discussed previously in conjunction with FIG. 1, the T-match configuration formed by inductors 952, 954 and shunt capacitor 956 may function as a low-pass matching stage. Further, the conductive bond pad 859 to which wirebonds 952 and 954 are coupled may correspond to an RF low-impedance point node, or a "quasi-RF cold point node" (e.g., node 158, FIG. 1), in an embodiment. According to an embodiment, both an in-package and an out-of-package baseband termination circuit 860-4, 870-2 are electrically coupled to conductive bond pad 859 (i.e., to the quasi-RF cold point node).

The in-package baseband termination circuit 860-4 is included in IPD assembly 883, in an embodiment. Baseband termination circuit 860-4 may have any one of a number of configurations, in various embodiments, such as but not limited to one of the configurations illustrated in FIGs 2-6. In the embodiment illustrated in FIGs 8-11, which corresponds to the baseband termination circuit 260 of FIG. 2, the baseband termination circuit 860-4 includes a multiple-cell resonator 961 (e.g., resonator 261, FIG. 2), an envelope resistor 965 (e.g., resistor 265, FIG. 2), and an envelope capacitor 966 (e.g., capacitor 266, FIG. 2) coupled in series between bond pad 859 (e.g., node 158, FIG. 1, or input 258, FIG. 2) and a ground reference node (e.g., conductive layer 1186).

The multiple-cell resonator 961 includes a plurality of resonator cells 962 (e.g., cells 262, FIG. 2) that are arranged side-by-side across the width of IPD assembly 883. According to one or more embodiments, no other circuitry is physically located between adjacent resonator cells 962 of the multiple-cell resonator 961. In other words, the multiple-cell resonator 961 is the only circuitry that is located in the area of the IPD assembly 883 between bond pad 859 and envelope resistor 965. In the embodiments of FIGs 8-11, twelve resonator cells 962 extend across the width of the IPD assembly 883 (i.e., *N* = 12). More specifically, the resonator cells 962 are connected in parallel between bond pad 859 and envelope resistor 965, in the illustrated embodiment. In an alternate embodiment, the multiple-cell resonator 961 may include more or fewer resonator cells 962.

As best seen in FIG. 10, each resonator cell 962 includes an RF isolation inductor 963 (e.g., inductance 263, FIG. 2) and an RF isolation capacitor 964 (e.g., capacitance 264, FIG. 2) coupled in parallel. More specifically, first terminals of the RF isolation inductors 963 and the RF isolation capacitors 9264 are coupled together (and to bond pad 859), and second terminals of the RF isolation inductors 963 and the RF isolation capacitors 964 are coupled together (and to envelope resistor 965).

The RF isolation inductors 963 also may be integrally formed as part of the IPD assembly 883, as is illustrated in the embodiment of FIGs 9, 11. For example, each RF isolation inductor 963 may include a spiral inductor formed from portion(s) of one or more conductive layers of the build-up structure 1184, where a first end (or terminal) of the spiral inductor is electrically coupled to bond pad 859, and a second end (or terminal) of the spiral inductor is electrically coupled to envelope resistor 965. One or more conductive vias 1063 and conductive underpasses 1064 may be used to electrically connect the second end of the spiral inductor to the envelope resistor 965, as shown in FIG. 10. Alternatively, the first end of the spiral inductor may be electrically connected to the bond pad 859 using conductive vias and underpasses.

As indicated previously, the spiral structure of each RF isolation inductor 963 enables a long electrical length to be achieved between relatively closely-spaced terminals. Thus, implementing the RF isolation inductors 963 as spiral inductors is beneficial in that the implementation enables the inductors 963 to fit in a relatively small area, despite having relatively high inductance values. Additionally, the multiple coils in each RF isolation inductor 963 may exhibit significant mutual inductance, which further increases the inductance value of each RF isolation inductor 963.

The RF isolation capacitors 964 also may be integrally formed as part of the IPD assembly 883, as is illustrated in the embodiment of FIGs 9, 11. For example, each RF isolation capacitor 964 may be implemented as an integrated MIM capacitor, which include first and second conductive electrodes (e.g., electrodes 964-1, 964-2, FIG. 10), and which may be formed from patterned portions of the conductive layers of build-up structure 1184. The electrodes 964-1, 964-2 are aligned with each other and are electrically separated by dielectric material of the build-up structure 1184. A first electrode 964-1 of each RF isolation capacitor 964 is electrically coupled to the conductive bond pad 859, and a second electrode 964-2 of each RF isolation capacitor 956 is electrically coupled to the envelope resistor 965, in an embodiment. According to one or more alternate embodiments, each of the RF isolation capacitors 964 may be implemented as a discrete capacitor that is connected (e.g., using solder, a conductive epoxy, or other means) to conductive terminals at a top surface of IPD assembly 883.

In the embodiments of FIGs 8-11, envelope resistor 965 is integrally formed as part of the IPD assembly 883. For example, the envelope resistor 965 may be a polysilicon resistor formed from a layer of polysilicon on or within build-up structure 1184, and electrically coupled between the multiple-cell resonator 961 and the envelope capacitor 966. In other alternate embodiments, the envelope resistor 965 may be formed from tungsten silicide or another material, may be a thick or thin film resistor, or may be a discrete component coupled to conductive pads at a top surface of IPD assembly 883.

The envelope capacitor 966 is electrically coupled between the envelope resistor 965 and a ground reference node (e.g., conductive layer 1186 at the bottom surface of each IPD assembly 883). Capacitor 966 may be a MIM capacitor that is integrally formed with the IPD substrate of IPD assembly 883, for example. In some embodiments, capacitor 966 may be formed in the build-up structure 1184 entirely above the semiconductor substrate 1182, or capacitor 966 may have portions that extend into the semiconductor substrate 1182 or are otherwise coupled to, or in contact with, the semiconductor substrate 1182. According to an embodiment, the capacitor 966 may be formed from a first electrode 1066-1, a second electrode 1066-2, and a dielectric material between the first and second electrodes. The dielectric material of capacitor 966 may include one or more layers of polysilicon, various oxides, a nitride, or other suitable materials. In various embodiments, the first and second electrodes 1066-1, 1066-2 of capacitor 966 may include horizontal portions of conductive layers (e.g., portions that are parallel to the top and bottom surfaces of IPD assembly 883) and/or vertical portions (e.g., portions that are parallel to the sides of IPD assembly 883) of conductive layers that are interconnected. Further, the first and second electrodes 1066-1, 1066-2 of capacitor 966 may be formed from metal layers and/or from conductive semiconductor materials (e.g., polysilicon). Alternatively, each envelope capacitor 966 may be, for example, a discrete capacitor that is connected (e.g., using solder, a conductive epoxy, or other means) to conductive pads at a top surface of the IPD assembly 883. Although particular two-plate capacitor structures are shown in FIGs 10 and 11 for capacitors 956, 964, and 966, a variety of other capacitor structures alternatively may be utilized, as would be understood by one of skill in the art based on the description herein.

Referring again to FIG. 8, each of the output-side, out-of-package baseband termination circuits 870-1, 870-2 includes a combination of an envelope inductance and an envelope capacitance coupled in series between a conductive bond pad 858, 859 (e.g., a quasi-RF cold point node) and ground. The envelope inductance is provided by the series combination of wirebonds (e.g., wirebonds 990, FIG. 9) and additional lead 894, 895 (FIG. 8), and the envelope capacitance is provided by a discrete capacitor 898-2, 899-2 (FIG. 8). More specifically, the first ends of the wirebonds (e.g., wirebonds 990, FIG. 9) may be connected to the conductive bond pad 858, 859 of an IPD assembly 882, 883, and the second ends of the wirebonds may be connected to a proximal end of the additional lead 894, 895. A first terminal of each envelope capacitor 898-2, 899-2 is coupled to a distal end of an additional lead 894, 895, and a second terminal of each capacitor 898-2, 899-2 is coupled to a ground reference node of a PCB (or other substrate) to which the amplifier device 800 is coupled.

FIGs 8-11 illustrate embodiments of RF amplifier devices that include input and output leads coupled to a substrate (e.g., with intervening electrical isolation), and a transistor die also coupled to the substrate between the input and output leads. Such RF amplifier devices may be particularly well suited for high-power amplification. Those of skill in the art would understand, based on the description herein, that the various embodiments may be implemented using different forms of packaging or construction, as well. For example, one or multiple amplification paths that include embodiments of the inventive subject matter could be coupled to a substrate such as a PCB, a no-leads type of package (e.g., a quad-flat no-leads (QFN) package), or another type of package. In such embodiments, inputs and outputs of the amplification path(s) could be implemented using conductive lands or other input/output (I/O) structures. Such implementations may be particularly suitable for lower-power amplification systems, for example, including a relatively low-power Doherty amplifier in which carrier and peaking amplification paths (including bare transistor dies, IPDs, bias circuits, and so on), a power divider, delay and impedance inversion elements, a combiner, and other components may be coupled to the substrate. It should be understood that implementations of the inventive subject matter are not limited to the illustrated embodiments.

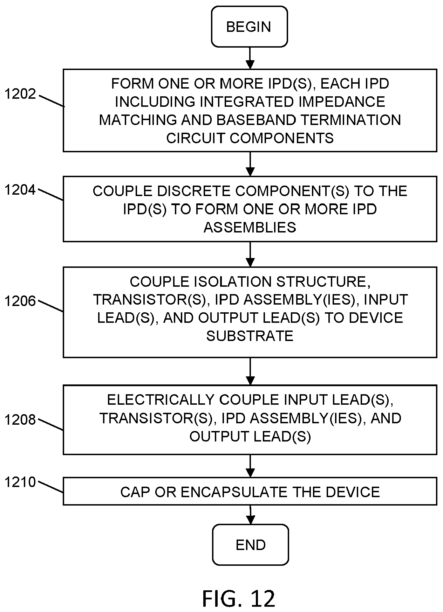

FIG. 12 is a flowchart of a method for fabricating a packaged RF power amplifier device (e.g., device 800, FIG. 8) that includes embodiments of input and output impedance matching circuits and baseband termination circuits (e.g., circuits 110, 150, 160-1, 160-2, 260, 360, 460, 560, 660, 710, 711, 750, 751, 760-1, 760-2, 760-3, 760-4, 810, 811, 850, 851, 860-1, 860-2, 860-3, 860-4, FIGs 1-11), in accordance with various example embodiments. The method may begin, in blocks 1202-1204, by forming one or more IPD assemblies. More specifically, in block 1202 ("Form one or more IPD(s), each IPD including integrated impedance matching and baseband termination circuit components"), one or more input and output IPDs (e.g., IPDs 880-883, FIGs 8-11) may be formed. According to an embodiment, each input IPD (e.g., IPDs 880, 881) may include components of an impedance matching circuit and a baseband termination circuit. According to an embodiment, each output IPD (e.g., IPDs 882, 883) also may include components of an impedance matching circuit and a baseband termination circuit. For example, each output IPD may include one or more integrated capacitors (e.g., capacitors 956, 964, 966, FIGs 9, 11), one or more inductances (e.g., inductive elements 963, FIGs 9-11), and one or more resistors (e.g., resistors 965, FIGs 9-11). In addition to forming the passive components of each IPD, forming each IPD also includes forming various conductive features (e.g., conductive layers and vias), which facilitate electrical connection between the various components of each circuit. For example, forming the IPDs also may include forming various bond pads (e.g., bond pads 818, 819, 858, 859, FIGs 8-11) at a surface of each IPD substrate. The bond pads may be configured to accept attachment of inductive elements (e.g., wirebonds 952, 954, FIGs 9, 11). In addition, in block 1204 ("Couple discrete component(s) to the IPD(s) to form one or more IPD assemblies"), discrete components corresponding to various circuit elements (e.g., discrete capacitors or resistors) may be coupled to conductors exposed at the surface of each IPD to form one or more IPD assemblies (e.g., IPD assemblies 880-883).

In block 1206 ("Couple isolation structure, transistor(s), IPD assembly(ies), input lead(s), and output lead(s) to device substrate"), for an air cavity embodiment, an isolation structure (e.g., isolation structure 808, FIG. 8) is coupled to a device substrate (e.g., flange 806). In addition, one or more active devices (e.g., transistors 840, 841) and the IPD assemblies (e.g., IPD assemblies 880-883) are coupled to a portion of the top surface of the substrate that is exposed through an opening in the isolation structure. Leads (e.g., input and output leads 802-805, and additional leads 894, 895, if included) are coupled to the top surface of the isolation structure. For overmolded (e.g., encapsulated) device embodiments, the isolation structure may be excluded, and the substrate and leads may form portions of a leadframe.

In block 1208 ("Electrically couple input lead(s), transistor(s) IPD assembly(ies), and output lead(s)"), the input lead(s), transistor(s), IPD assembly(ies), and output lead(s) are electrically coupled together. For example, the electrical connections may be made using wirebonds between the various device components and elements, as discussed previously. Some of the wirebonds correspond to inductive components of input or output matching circuits (e.g., wirebonds 952, 954, FIGs 8, 9, and 11). Finally, in block 1210 ("Cap or encapsulate the device"), the device is capped (e.g., for an air cavity package) or encapsulated (e.g., with mold compound for an overmolded package). The device may then be incorporated into a larger electrical system (e.g., a Doherty amplifier or other type of electrical system). As discussed previously, when incorporated into a larger electrical system, the device may be coupled to a PCB. According to one or more embodiments, out-of-package baseband termination circuits (e.g., circuits 169, 170, 769-1, 769-2, 770-1, 770-2, 869-1, 869-2, 870-1, 870-2, FIGs 1, 7, 8) may be established using additional wirebonds (e.g., wirebonds 990, FIG. 9) between the IPD assembly(ies) and extra leads (e.g., leads 192, 194, 892-895, FIGs 1, 8), and capacitors (e.g., capacitors 898-1, 898-2, 899-1, 899-2, FIG. 8) coupled between the extra leads and a ground reference node of the PCB.

One or more embodiments of an RF amplifier with a first amplification path include a transistor die (840, 841), an impedance matching circuit (110, 150, 810, 811, 850, 851), and a baseband termination circuit (160-1, 160-2, 260, 360, 460, 560, 660, 760-1, 760-2, 760-3, 760-4, 860-1, 860-2, 860-3, 860-4). The transistor die (840, 841) has a transistor (140) and a transistor terminal (142, 144). The impedance matching circuit (110, 150, 810, 811, 850, 851) has a T-match circuit topology coupled between the transistor terminal and an RF input/output (102, 104, 802, 803, 804, 805) of the first amplification path. The impedance matching circuit includes a first inductive element (112, 152, 952) connected between the transistor terminal and a first node (118, 158, 818, 819, 858, 859), a second inductive element (116, 154, 954) connected between the first node and the RF input/output of the first amplification path, and a first capacitance (114, 156, 956) connected between the first node and a ground reference node. The baseband termination circuit (160-1, 160-2, 260, 360, 460, 560, 660, 760-1, 760-2, 760-3, 760-4, 860-1, 860-2, 860-3, 860-4) is connected to the first node, and the baseband termination circuit includes a multiple-cell resonator (261, 261', 961) and an envelope capacitor (266, 966) coupled in series between the first node and the ground reference node. The multiple-cell resonator includes a number, $N$, of resonator cells (262, 262', 962), wherein $N$ is at least 4. Each resonator cell includes an RF isolation inductor (263, 963) and an RF isolation capacitor (264, 964) coupled in parallel between the first node and the envelope capacitor. The RF isolation inductor and the RF isolation capacitor form a parallel resonant circuit in proximity to a center operating frequency of the RF amplifier. Various embodiments of the baseband termination circuit also include one or more envelope resistors (265, 665, 965). According to one or more embodiments, the first node is a quasi-RF cold point node.

According to one or more further embodiments, the resonator cells are integrally formed in an integrated passive device (880, 881, 882, 883), and the resonator cells are arranged side-by-side across a width of the integrated passive device, where no other circuitry is physically located between adjacent resonator cells of the multiple-cell resonator.

According to one or more further embodiments, the RF amplifier is a Doherty power amplifier that also includes a second amplification path (721, 821), a power divider (706), and a combining node (780). The power divider (706) has a power divider input configured to receive an RF signal, a first power divider output (708) coupled to an input of the first amplification path (720, 820), and a second power divider output (709) coupled to an input of the second amplification path (721, 821). The power divider is configured to divide the RF signal into a first RF signal that is provided to the first amplification path through the first power divider output, and into a second RF signal that is provided to the second amplification path through the second power divider output. The combining node (780) is configured to receive and combine amplified RF signals produced by the first and second amplification paths.

One or more embodiments of a packaged RF amplifier device (800) include a device substrate (806), an input lead (802, 803) coupled to the device substrate, an output lead (804, 805) coupled to the device substrate, and a transistor die (840, 841) coupled to the device substrate. The transistor die includes a first transistor (140), a transistor input terminal (142) coupled to the input lead, and a transistor output terminal (144, 944) coupled to the output lead. The packaged RF amplifier device also includes an output-side impedance matching circuit (150, 850, 851) having a T-match circuit topology coupled between the transistor output terminal and the output lead. The output-side impedance matching circuit includes a first inductive element (152, 952) connected between the transistor output terminal and a first node (158, 858, 859), a second inductive element (154, 954) connected between the first node and the output lead, and a first capacitance (156, 956) connected between the first node and a ground reference node. The first inductive element includes a first plurality of wirebonds (952), and the second inductive element includes a second plurality of wirebonds (954).

The one or more embodiments of the packaged RF amplifier device also include a baseband termination circuit (160-2, 260, 360, 460, 560, 660, 760-2, 760-4, 860-2, 860-4) connected to the first node. The baseband termination circuit includes a multiple-cell resonator (261, 261', 961) and an envelope capacitor (266, 966) coupled in series between the first node and the ground reference node. The multiple-cell resonator includes a number, N, of resonator cells (262, 262', 962), where N is at least 4, and where each resonator cell includes an RF isolation inductor (263, 963) and an RF isolation capacitor (264, 964) coupled in parallel between the first node and the envelope capacitor. The RF isolation inductor and the RF isolation capacitor form a parallel resonant circuit in proximity to a center operating frequency of the RF amplifier.

According to one or more further embodiments, the packaged RF amplifier device also includes an integrated passive device (882, 883) coupled to the device substrate between the first transistor die and the first output lead. The integrated passive device includes the first capacitance, the multiple-cell resonator, the envelope capacitance, and a bond pad (858, 859) corresponding to the first node. The resonator cells are arranged side-by-side across a width of the integrated passive device, and no other circuitry is physically located between adjacent resonator cells of the multiple-cell resonator. According to one or more further embodiments, the RF isolation inductor is an integrated spiral inductor (963).

According to one aspect of the present disclosure, there is provided A packaged radio frequency (RF) amplifier device (800) comprising: a device substrate (806); an input lead (802, 803) coupled to the device substrate; an output lead (804, 805) coupled to the device substrate; a transistor die (840, 841) coupled to the device substrate, wherein the transistor die includes a first transistor (140), a transistor input terminal (142) coupled to the input lead, and a transistor output terminal (144, 944) coupled to the output lead; an output-side impedance matching circuit (150, 850, 851) having a T-match circuit topology coupled between the transistor output terminal and the output lead, wherein the output-side impedance matching circuit includes a first inductive element (152, 952) connected between the transistor output terminal and a first node (158, 858, 859), wherein the first inductive element includes a first plurality of wirebonds

(952), a second inductive element (154, 954) connected between the first node and the output lead, wherein the second inductive element includes a second plurality of wirebonds (954), and a first capacitance (156, 956) connected between the first node and a ground reference node; and a baseband termination circuit (160-2, 260, 360, 460, 560, 660, 760-2, 760-4, 860-2, 860-4) connected to the first node, wherein the baseband termination circuit includes a multiple-cell resonator (261, 261', 961) and an envelope capacitor (266, 966) coupled in series between the first node and the ground reference node, and wherein the multiple-cell resonator includes a number, N, of resonator cells (262, 262', 962), wherein N is at least 4, and wherein each resonator cell includes an RF isolation inductor (263, 963) and an RF isolation capacitor (264, 964) coupled in parallel between the first node and the envelope capacitor, and wherein the RF isolation inductor and the RF isolation capacitor form a parallel resonant circuit in proximity to a center operating frequency of the RF amplifier. In one or more embodiments, the packaged RF amplifier device further comprises: an integrated passive device (882, 883) coupled to the device substrate between the first transistor die and the first output lead, wherein the integrated passive device includes the first capacitance, the multiple-cell resonator, the envelope capacitance, and a bond pad (858, 859) corresponding to the first node, and wherein the resonator cells are arranged side-by-side across a width of the integrated passive device, and no other circuitry is physically located between adjacent resonator cells of the multiple-cell resonator. The RF isolation inductor may be an integrated spiral inductor (963).

One or more embodiments of a method of manufacturing an RF amplifier device (800) include the steps of coupling an output lead (804, 805) to a device substrate (806), coupling a transistor die (840, 841) to the device substrate, and coupling an integrated passive device (882, 883) to the device substrate between the transistor die and the output lead. The transistor die includes a transistor (140) and a transistor output terminal (144, 944). The integrated passive device includes a first node (158, 858, 859), a ground reference node (1186), a first capacitor (156, 956) coupled between the first node and the ground reference node, and a baseband termination circuit (160-2, 260, 360, 460, 560, 660, 760-2, 760-4, 860-2, 860-4) coupled between the first node and the ground reference node. The baseband termination circuit includes a multiple-cell resonator (261, 261', 961) and an envelope capacitor (266, 966) coupled in series between the first node and the ground reference node. The multiple-cell resonator includes a number, N, of resonator cells (262, 262', 962), where N is at least 4, and where each resonator cell includes an RF isolation inductor (263, 963) and an RF isolation capacitor (264, 964) coupled in parallel between the first node and the envelope capacitor. The RF isolation inductor and the RF isolation capacitor form a parallel resonant circuit in proximity to a center operating frequency of the RF amplifier. The method further includes creating an output-side impedance matching circuit (150, 750, 751, 850, 851) with a T-match circuit topology between the transistor output terminal and the output lead. The T-match circuit topology includes the first capacitor, and the output-side impedance matching circuit is created by coupling a first inductive element (152, 952) between the transistor output terminal and the first node, and coupling a second inductive element (154, 954) between the first node and the output lead. The first inductive element includes a first plurality of wirebonds (952), and the second inductive element includes a second plurality of wirebonds (954).

The preceding detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first," "second" and other such numerical terms referring to structures do not imply a sequence or order unless clearly indicated by the context.

As used herein, a "node" means any internal or external reference point, connection point, junction, signal line, conductive element, or the like, at which a given signal, logic level, voltage, data pattern, current, or quantity is present. Furthermore, two or more nodes may be realized by one physical element (and two or more signals can be multiplexed, modulated, or otherwise distinguished even though received or output at a common node).

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

**Claims**

1. A radio frequency (RF) amplifier (100, 700) with a first amplification path (720, 820) that comprises:

   a transistor die (840, 841) with a transistor (140) and a transistor terminal (142, 144);
   an impedance matching circuit (110, 150, 810, 811, 850, 851) having a T-match circuit topology coupled between the transistor terminal and an RF input/output (102, 104, 802, 803, 804, 805) of the first amplification path, wherein the impedance matching circuit includes

   a first inductive element (112, 152, 952) connected between the transistor terminal and a first node (118, 158, 818, 819, 858, 859),
   a second inductive element (116, 154, 954) connected between the first node and the RF input/output of the first amplification path, and
   a first capacitance (114, 156, 956) connected between the first node and a ground reference node; and

   a baseband termination circuit (160-1, 160-2, 260, 360, 460, 560, 660, 760-1, 760-2, 760-3, 760-4, 860-1, 860-2, 860-3, 860-4) connected to the first node, wherein the baseband termination circuit includes a multiple-cell resonator (261, 261', 961) and an envelope capacitor (266, 966) coupled in series between the first node and the ground reference node, and wherein the multiple-cell resonator includes a number, N, of resonator cells (262, 262', 962), wherein N is at least 4, and wherein each resonator cell includes an RF isolation inductor (263, 963) and an RF isolation capacitor (264, 964) coupled in parallel between the first node and the envelope capacitor, and wherein the RF isolation inductor and the RF isolation capacitor form a parallel resonant circuit in proximity to a center operating frequency of the RF amplifier.

2. The RF amplifier of claim 1, wherein N is in a range of 4 to 20.

3. The RF amplifier of claim 1, wherein the resonator cells are integrally formed in an integrated passive device (880, 881, 882, 883), the resonator cells are arranged side-by-side across a width of the integrated passive device, and no other circuitry is physically located between adjacent resonator cells of the multiple-cell resonator.

4. The RF amplifier of claim 1, wherein the transistor terminal is a transistor drain terminal (144, 944), the RF input/output is an output (104, 804, 805), and the impedance matching circuit is an output impedance matching circuit (150, 850, 851).

5. The RF amplifier of claim 1, wherein the first node is a quasi-RF cold point node.

6. The RF amplifier of claim 1, wherein the baseband termination circuit also includes an envelope resistor (265, 965) coupled in series with the multiple-cell resonator and the envelope capacitor between the first node and the ground reference node.

7. The RF amplifier of claim 6, wherein the multiple-cell resonator is connected between the first node and a second node (268), the envelope resistor is connected between the second node and a third node (269), and the envelope capacitor is connected between the third node and the ground reference node.

8. The RF amplifier of claim 7, wherein the baseband termination circuit further comprises a bypass capacitor (276) coupled in parallel with the envelope resistor.

9. The RF amplifier of claim 6, wherein the envelope resistor is connected between the first node and a second node (268), the multiple-cell resonator is connected between the second node and a third node (269), and the envelope capacitor is connected between the third node and the ground reference node.

10. The RF amplifier of claim 9, wherein the baseband termination circuit further comprises a bypass capacitor (276) coupled in parallel with the envelope resistor.

11. The RF amplifier of claim 1, wherein each resonator cell further includes an envelope resistor (665) coupled in series with the RF isolation inductor.

12. The RF amplifier of claim 1, wherein the RF amplifier is a Doherty power amplifier (700) further comprising:

a second amplification path (721, 821);
a power divider (706) with a power divider input configured to receive an RF signal, a first power divider output (708) coupled to an input of the first amplification path (720, 820), and a second power divider output (709) coupled to an input of the second amplification path (721, 821), wherein the power divider is configured to divide the RF signal into a first RF signal that is provided to the first amplification path through the first power divider output, and into a second RF signal that is provided to the second amplification path through the second power divider output; and
a combining node (780) configured to receive and combine amplified RF signals produced by the first and second amplification paths.

13. A method of manufacturing an RF amplifier device (800), the method comprising the steps of:

coupling an output lead (804, 805) to a device substrate (806);
coupling a transistor die (840, 841) to the device substrate, wherein the transistor die includes a transistor (140) and a transistor output terminal (144, 944);
coupling an integrated passive device (882, 883) to the device substrate between the transistor die and the output lead, wherein the integrated passive device includes a first node (158, 858, 859), a ground reference node (1186), a first capacitor (156, 956) coupled between the first node and the ground reference node, and a baseband termination circuit (160-2, 260, 360, 460, 560, 660, 760-2, 760-4, 860-2, 860-4) coupled between the first node and the ground reference node, wherein the baseband termination circuit includes a multiple-cell resonator (261, 261', 961) and an envelope capacitor (266, 966) coupled in series between the first node and the ground reference node, and wherein the multiple-cell resonator includes a number, N, of resonator cells (262, 262', 962), wherein N is at least 4, and wherein each resonator cell includes an RF isolation inductor (263, 963) and an RF isolation capacitor (264, 964) coupled in parallel between the first node and the envelope capacitor, and wherein the RF isolation inductor and the RF isolation capacitor form a parallel resonant circuit in proximity to a center operating frequency of the RF amplifier; and
creating an output-side impedance matching circuit (150, 750, 751, 850, 851) with a T-match circuit topology between the transistor output terminal and the output lead, wherein the T-match circuit topology includes the first capacitor, and the output-side impedance matching circuit is created by coupling a first inductive element (152, 952) between the transistor output terminal and the first node, wherein the first inductive element includes a first plurality of wirebonds (952), and coupling a second inductive element (154, 954) between the first node and the output lead, wherein the second inductive element includes a second plurality of wirebonds (954).

14. The method of claim 13, wherein the resonator cells are arranged side-by-side across a width of the integrated passive device, and no other circuitry is physically located between adjacent resonator cells of the multiple-cell resonator.

15. The method of claim 1613 or 14 wherein the baseband termination circuit also includes an envelope resistor (265, 965) coupled in series with the multiple-cell resonator and the envelope capacitor between the first node and the ground reference node.

**20**

FIG. 1

FIG. 2

FIG. 3

FIG. 4

FIG. 5

FIG. 6

FIG. 7

EP 4 756 876 A1

FIG. 8

FIG. 9

FIG. 10

FIG. 11

EP 4 756 876 A1

```
                    ┌─────────────┐
                    │    BEGIN    │
                    └─────────────┘
                           │
                           ▼
        ┌──────────────────────────────────────┐
        │   FORM ONE OR MORE IPD(S), EACH IPD   │
 1202 ──│     INCLUDING INTEGRATED IMPEDANCE    │
        │   MATCHING AND BASEBAND TERMINATION   │
        │          CIRCUIT COMPONENTS           │
        └──────────────────────────────────────┘
                           │
                           ▼
        ┌──────────────────────────────────────┐
        │   COUPLE DISCRETE COMPONENT(S) TO THE │
 1204 ──│     IPD(S) TO FORM ONE OR MORE IPD    │
        │              ASSEMBLIES               │
        └──────────────────────────────────────┘
                           │
                           ▼
        ┌──────────────────────────────────────┐
        │      COUPLE ISOLATION STRUCTURE,      │
        │  TRANSISTOR(S), IPD ASSEMBLY(IES), INPUT │
 1206 ──│   LEAD(S), AND OUTPUT LEAD(S) TO DEVICE │
        │              SUBSTRATE                │
        └──────────────────────────────────────┘
                           │
                           ▼
        ┌──────────────────────────────────────┐
        │    ELECTRICALLY COUPLE INPUT LEAD(S), │
 1208 ──│   TRANSISTOR(S), IPD ASSEMBLY(IES), AND │
        │            OUTPUT LEAD(S)             │
        └──────────────────────────────────────┘
                           │
                           ▼
 1210 ──┌──────────────────────────────────────┐
        │       CAP OR ENCAPSULATE THE DEVICE   │
        └──────────────────────────────────────┘
                           │
                           ▼
                    ┌─────────────┐
                    │     END     │
                    └─────────────┘
```

FIG. 12

## EUROPEAN SEARCH REPORT

**Application Number**

EP 24 30 7056

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/175860 A1 (ROBERTS JEFFREY SPENCER [US] ET AL) 10 June 2021 (2021-06-10) | 1,2, 4-13,15 | INV. H01L23/64 |
| Y | * paragraph [0022] - paragraph [0100]; figures 1-5, 7 * | 1-3,13, 14 | H01L23/66 |
| Y | CN 115 694 394 A (PINNACLE TECH CO LTD) 3 February 2023 (2023-02-03) | 1-3,13, 14 | |
| A | * the whole document * | 4-12,15 | |

**TECHNICAL FIELDS SEARCHED (IPC)**

H01L

The present search report has been drawn up for all claims

| Place of search | Date of completion of the search | Examiner |
|---|---|---|
| Munich | 23 May 2025 | Ardakanian, Niyousha |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

                                       

& : member of the same patent family, corresponding
document

EPO FORM 1503 03.82 (P04C01)

# EP 4 756 876 A1

## ANNEX TO THE EUROPEAN SEARCH REPORT
## ON EUROPEAN PATENT APPLICATION NO.

EP 24 30 7056

This annex lists the patent family members relating to the patent documents cited in the above-mentioned European search report.
The members are as contained in the European Patent Office EDP file on
The European Patent Office is in no way liable for these particulars which are merely given for the purpose of information.

23-05-2025

| Patent document cited in search report | Publication date | Patent family member(s) | Publication date |
|---|---|---|---|
| US 2021175860 A1 | 10-06-2021 | CN 112953415 A<br>EP 3836391 A1<br>US 2021175860 A1 | 11-06-2021<br>16-06-2021<br>10-06-2021 |
| CN 115694394 A | 03-02-2023 | NONE | |

EPO FORM P0459

For more details about this annex : see Official Journal of the European Patent Office, No. 12/82

32